# EUROPEAN PATENT APPLICATION

(11) **EP 4 815 696 A1**
(43) Date of publication of application: **30.09.2026**
(21) Application number: 24904435.5
(22) Date of filing: 13.12.2024
(51) Int. Cl.: H10K 59/131, H10K 77/10, G09F 9/30, H10H 20/857, H01L 25/075, H10H 29/01, H10K 59/121, H10K 59/123, H10K 102/00

(54) **DISPLAY DEVICE**

(30) Priority: 15.12.2023 KR 20230182944
(71) Applicant: Samsung Display Co., Ltd., Yongin-si, Gyeonggi-do 17113 (KR)
(72) Inventor: SEO, Woo Suk, Yongin-si, Gyeonggi-do 17113 (KR); LEE, Tae Ho, Yongin-si, Gyeonggi-do 17113 (KR); KIM, Seong Won, Yongin-si, Gyeonggi-do 17113 (KR)
(74) Representative: Walaski, Jan Filip
(86) International application number: PCT/KR2024/096936
(87) International publication number: WO 2025/127870

(57) **Abstract**

An embodiment of the disclosure discloses a display apparatus, including a display area and a non-display area outside the display area, includes island portions arranged in the display area and spaced apart from one another; bridge portions each connecting island portions adjacent to each other among the island portions; and wirings arranged in each of the bridge portions, where each of wirings includes a first layer, the first layer includes a first sub layer including an alloy of aluminum and a rare-earth element, and a second sub layer comprises aluminum.

## Description

### Technical Field

Embodiments of the disclosure relate to a display apparatus, for example, a flexible display apparatus.

### Background Art

Due to the development of display apparatuses configured to visually display electrical signals, various kinds of display apparatuses having excellent characteristics such as being thin and lightweight, and having low power consumption, have been introduced. For example, flexible display apparatuses that may be folded or rolled have been introduced. Recently, there has been ongoing research and development of stretchable display apparatuses that may be transformed into various shapes.

### Disclosure of Invention

### Technical Problem

Embodiments of the disclosure provide a flexible display apparatus, for example, a stretchable display apparatus. However, the technical goal is only an example, and the scope of the embodiments is not limited thereto.

### Solution to Problem

In one aspect of the present invention, a display apparatus, including a display area and a non-display area outside the display area, includes: island portions arranged in the display area and spaced apart from one another; bridge portions each connecting island portions adjacent to each other among the island portions; and wirings arranged in each of the bridge portions, where each of the wirings includes a first layer, the first layer includes a first sub layer and a second sub layer, and the first sub layer includes an alloy of aluminum (AI) and a rare-earth element and a second sub layer comprises aluminum.

In another aspect of the present invention, a display apparatus including a display area and a non-display area outside the display area, the display apparatus including island portions arranged in the display area and each including a transistor and a light-emitting element electrically connected to the transistor, and bridge portions each connecting island portions adjacent to each other among the island portions, where each of the bridge portions includes a wiring electrically connected to a transistor of any one of the island portions adjacent to each other, the wiring includes a first layer, and the first layer includes a first sub layer, which includes an alloy of aluminum and a rare-earth element, and a second sub layer comprising aluminum.

### Advantageous Effects of Invention

According to an embodiment, a display apparatus capable of preventing damages caused by concentration of stress and extending/contracting in various directions may be provided. However, the scope of the disclosure is not limited thereto.

### Brief Description of Drawings

FIG. 1 is a perspective view schematically illustrating a display apparatus according to an embodiment.
FIGS. 2A and 2B are perspective views each illustrating a state in which the display apparatus shown in FIG. 1 is stretched in a first direction.
FIG. 2C is a perspective view illustrating a state in which the display apparatus shown in FIG. 1 is stretched in a second direction.
FIG. 2D is a perspective view illustrating a state in which the display apparatus shown in FIG. 1 is stretched in the first direction and the second direction.
FIG. 2E is a perspective view illustrating a state in which the display apparatus shown in FIG. 1 is stretched in a third direction.
FIG. 3 is a plan view schematically illustrating a display apparatus according to an embodiment.
FIG. 4A is an enlarged plan view of a portion IV shown in FIG. 3 as a portion of a display apparatus according to an embodiment.
FIG. 4B is an enlarged plan view of the portion IV shown in FIG. 3 as a portion of a display apparatus according to another embodiment.
FIG. 4C is an enlarged plan view of the portion IV shown in FIG. 3 as a portion of the display apparatus according to still another embodiment.
FIG. 5 is a cross-sectional view schematically illustrating a first island portion and a first bridge portion arranged in a display area of a display apparatus according to an embodiment.
FIGS. 6A to 6C are each an equivalent circuit diagram of a subpixel of a display apparatus according to an embodiment.
FIG. 7A is a cross-sectional view schematically illustrating a light-emitting element of a display apparatus according to an embodiment.
FIG. 7B is a cross-sectional view schematically illustrating a light-emitting element of a display apparatus according to an embodiment;
FIG. 8A is an enlarged plan view of a first island portion of a display apparatus according to an embodiment.
FIG. 8B is a plan view illustrating an arrangement of wirings in a first bridge portion of a display apparatus according to an embodiment.
FIG. 9 illustrates a cross-section taken along line I-I' shown in FIG. 8A and a cross-section taken along line II-II' shown in FIG. 8B.
FIG. 10 is a cross-sectional view of a conductive layer forming a wiring or a connection electrode of a display apparatus according to an embodiment.
FIG. 11 is a cross-sectional view of a conductive layer of a display apparatus according to another embodiment.
FIG. 12 is a cross-sectional view of a conductive layer of a display apparatus according to a comparative example.
FIG. 13 is a flowchart showing a method of manufacturing an alloy layer included in a conductive layer, according to an embodiment.
FIG. 14 illustrates a microstructure of an alloy layer according to an embodiment.
FIG. 15 illustrates a microstructure of a conductive layer according to an embodiment.
FIG. 16 is a graph showing resistivity of a conductive layer, according to embodiments.
FIG. 17 is a graph showing resistivity of a conductive layer, according to embodiments and comparative examples.
FIG. 18 is a graph showing results of a tensile test of a conductive layer according to comparative examples.
FIG. 19 is a graph showing results of a tensile test of a conductive layer according to embodiments.
FIG. 20 is a graph showing results of a tensile test of a conductive layer according to other embodiments.
FIGS. 21A to 21G are perspective views each schematically illustrating an embodiment of an electronic device including a display apparatus according to an embodiment.

### Best Mode for Carrying out the Invention

In an embodiment, each of the first sub layer and the second sub layer may be provided in plurality, and the first layer may have a structure in which the first sub layers and the second sub layers are alternately stacked.

In an embodiment, two first sub layers of the first sub layer may be disposed on a top and a bottom of the first layer, respectively.

In an embodiment, the first sub layer may include an amorphous alloy layer.

In an embodiment, the rare-earth element may include at least one of yttrium (Y), samarium (Sm), cerium (Ce), or lanthanum (La).

In an embodiment, a content of the rare-earth element may be 4 atomic percentages (at%) to 10 at% with respect to a total atomic weight of the first sub layer.

In an embodiment, a ratio of a thickness of each of the first sub layers to a thickness of each of the second sub layers may be greater than 0 and not more than 1.

In an embodiment, resistivity of the first layer may be greater than 5.6 and less than 11 microohm-centimeters (µΩ·cm).

In an embodiment, an elastic strain limit of the first layer may be at least 2.0 %.

In an embodiment, a yield strength of the first layer may be 0.8 gigapascals (GPa) to 1.2 GPa.

In an embodiment, each of the wirings may further include a second layer under the first layer and a third layer on the first layer, and the second layer and the third layer may include a material different from a material of the first layer.

In an embodiment, each of the island portions may include a transistor including a semiconductor and a gate electrode, a light-emitting element electrically connected to the transistor, and an electrode disposed between the gate electrode and the light-emitting element, where the electrode may include a third sub layer, which includes an alloy of aluminum and a rare-earth element, and a fourth sub layer comprising aluminum.

### Mode for the Invention

The disclosure may be modified in various ways and may have various embodiments, and specific embodiments will be illustrated in the drawings and described in detail in the detailed description. The effects and features of the disclosure, and methods of achieving the same, will become apparent with reference to the embodiments described in detail below together with the drawings. However, the disclosure is not limited to the embodiments disclosed herein but may be implemented in various forms.

Hereinafter, embodiments will be described in detail with reference to the accompanying drawings, and when describing with reference to the drawings, the same or corresponding components are given the same reference numerals, and duplicate descriptions thereof will be omitted.

In the following embodiments, the terms first, second, etc. are not intended to be limiting, however are used to distinguish one component from another component.

In the following embodiments, the singular expression includes the plural unless the context clearly indicates otherwise.

In the following embodiments, the terms including or that has, etc. are intended to imply the presence of the recited features or components and do not preclude the possibility of the addition of one or more other features or components.

In the following embodiments, when a portion of a film, area, component, etc. is said to be over or on the upper portion of another portion, this includes not only when it is directly on the upper portion of another portion, however also when there are other films, areas, components, etc. arranged therebetween.

In the drawings, components may be exaggerated or reduced in size for ease of illustration. For example, the size and thickness of each configuration shown in the drawings are arbitrary for ease of description and the disclosure is not necessarily limited to those shown.

In some embodiments, a particular sequence of processes may be performed in a different order than that described. For example, two processes described in succession may be performed substantially simultaneously, or may be performed in the opposite order from the order described.

As used herein, "A and/or B" refers to A, B, or both A and B. In addition, "at least one of A and B" represents the case of A, B, or A and B.

In the following embodiments, references to films, areas, components, etc. being connected include direct connections between films, areas, components, and/or indirect connections between films, areas, and components, with other films, areas, and components, arranged between them. For example, when referring to films, areas, components, etc. as being electrically connected herein, it refers to films, areas, components, etc. being directly electrically connected and/or indirectly electrically connected with other films, areas, components, etc. arranged therebetween.

An x-axis, a y-axis, and a z-axis are not limited to three axes on an orthogonal coordinate system, and may be interpreted as a wide meaning including the same. For example, the x-axis, y-axis, and z-axis may be orthogonal to one another, but may also refer to different directions that are not orthogonal to one another.

About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ± 10%, 5% or 2% of the stated value.

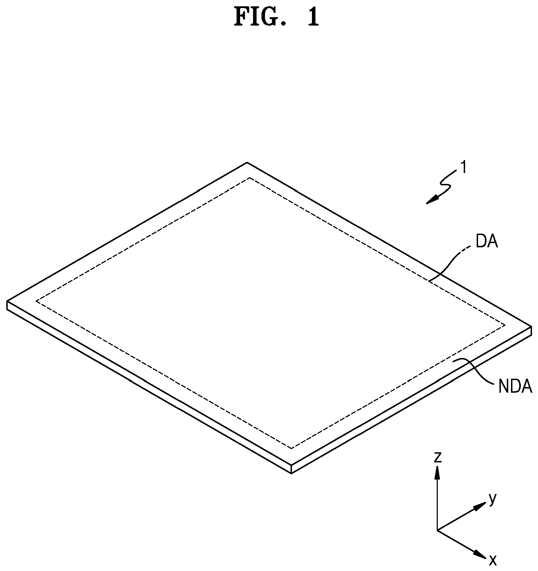

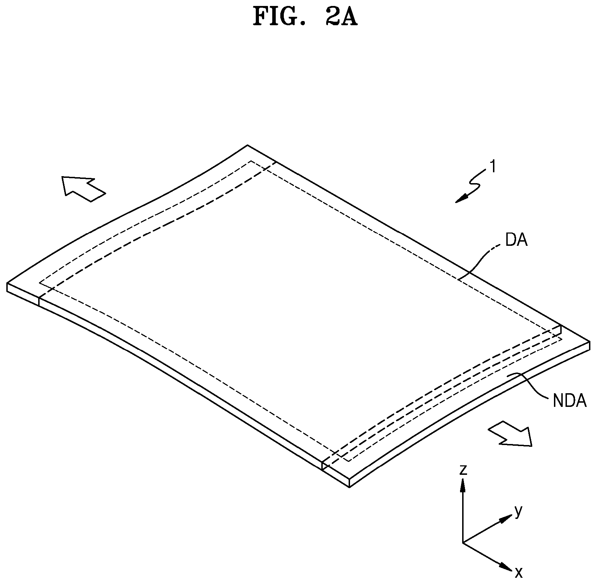

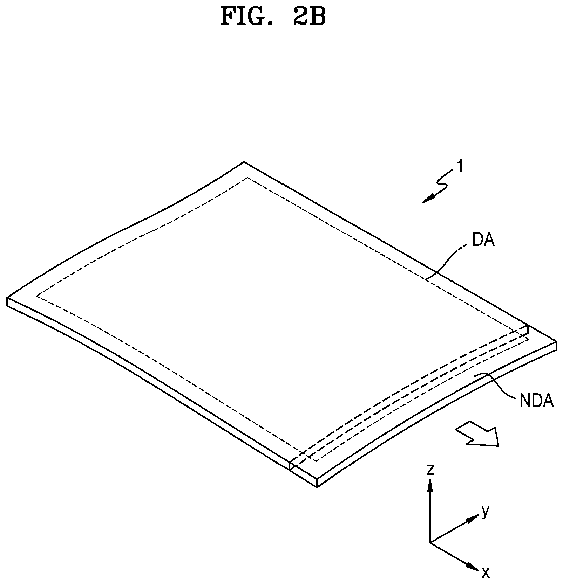

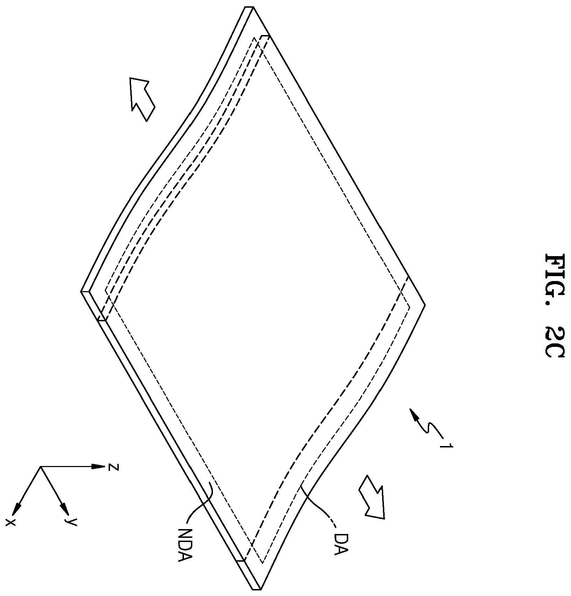

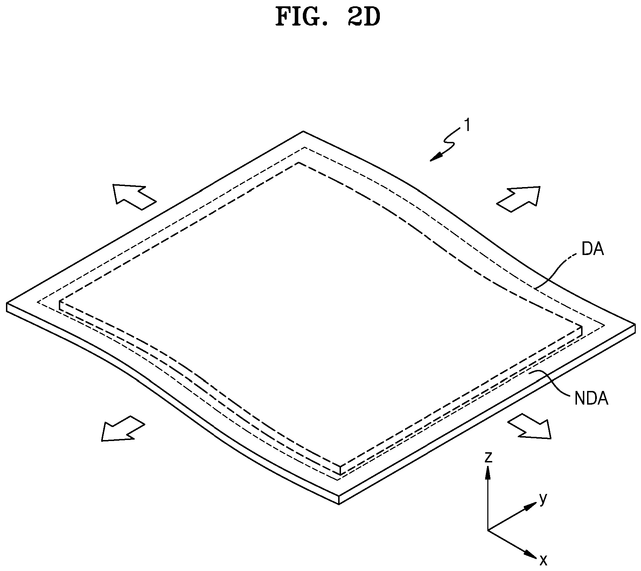

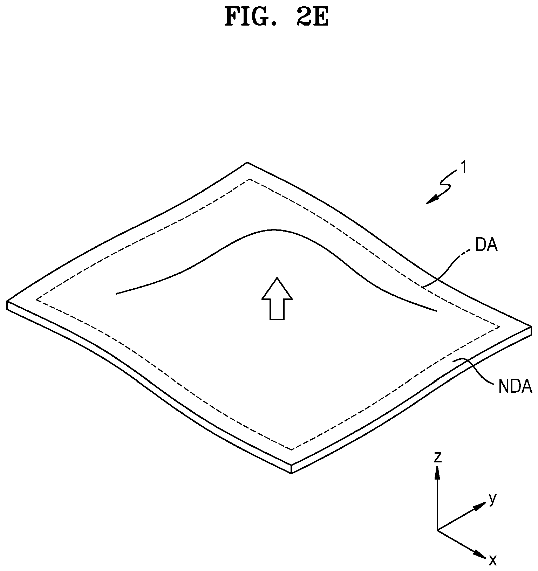

FIG. 1 is a perspective view schematically illustrating a display apparatus 1 according to an embodiment. FIGS. 2A and 2B are perspective views each illustrating a state in which the display apparatus 1 shown in FIG. 1 is stretched in a first direction. FIG. 2C is a perspective view illustrating a state in which the display apparatus 1 shown in FIG. 1 is stretched in a second direction. FIG. 2D is a perspective view illustrating a state in which the display apparatus 1 shown in FIG. 1 is stretched in the first direction and the second direction. FIG. 2E is a perspective view illustrating a state in which the display apparatus 1 shown in FIG. 1 is stretched in a third direction.

Referring to FIG. 1, the display apparatus 1 may include a display area DA and a non-display area NDA. The display area DA may include pixels. The display apparatus 1 may be configured to provide certain images by using light emitted from the pixels. The non-display area NDA may be arranged outside the display area DA. The non-display area NDA may generally surround the display area DA.

The display apparatus 1 may extend or shrink in various directions. The display apparatus 1 may extend in the first direction (e.g., a x direction and/or a - x direction) due to an external force applied by a foreign object or a user. In an embodiment, as shown in FIGS. 2A and 2B, the display area DA and/or the non-display area NDA of the display apparatus 1 may extend in the first direction (e.g., the x direction and/or the - x direction). For example, the display area DA and/or the non-display area NDA may extend in the x direction and the - x direction as shown in FIG. 2A, or may extend in the x direction in a state where a side of the display apparatus is fixed, as shown in FIG. 2B.

The display apparatus 1 may extend in the second direction (e.g., a y direction and/or a -y direction) by an external force applied by a foreign object or a user. In an embodiment, as shown in FIG. 2C, the display area DA and/the non-display area NDA of the display apparatus 1 may extend in the y direction and the - y direction. In another embodiment, the display area DA and/the non-display area NDA of the display apparatus 1 may extend in the y direction or the - y direction in a state where a side of the display apparatus 1 is fixed.

The display apparatus 1 may extend in directions, e.g., the first direction (e.g., the x direction and/or the - x direction) and the second direction (e.g., the y direction and/or the - y direction), due to an external force applied by a foreign object or a part of a human body. As shown in FIG. 2D, the display area DA and/or the non-display area NDA of the display apparatus 1 may extend in the ±x directions and ±y directions.

The display apparatus 1 may extend in a third direction (e.g., a z direction or a - z direction) due to an external force applied by a foreign object or a part of a human body. In an embodiment, FIG. 2E illustrates that a portion of the display apparatus 1, e.g., an area of the display area DA, protrudes in the z direction. In another embodiment, a portion of the display apparatus 1, e.g., an area of the display area DA, may protrude in the - z direction (or may be recessed in the z direction).

Although FIGS. 2A to 2E illustrate that the display apparatus 1 extends in the first direction, the second direction, and/or the third direction, the disclosure is not limited thereto. In another embodiment, the display apparatus 1 may be variously deformed into amorphous shapes, for example, may be bent or twisted with two or more axes.

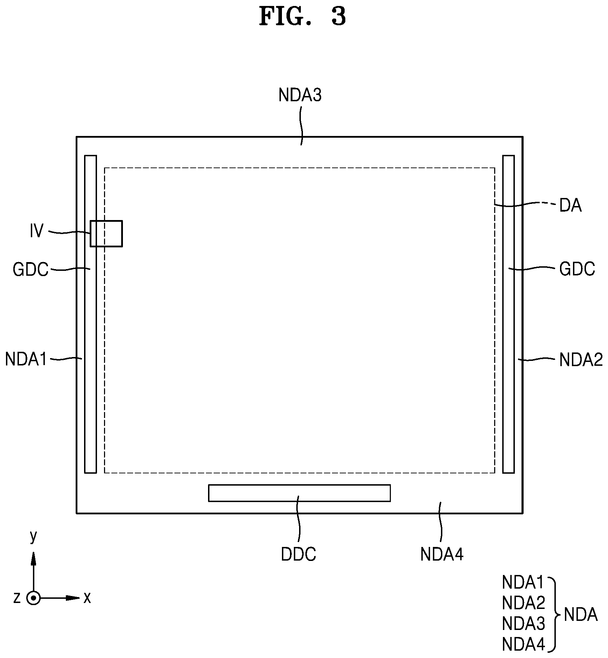

FIG. 3 is a plan view schematically illustrating the display apparatus 1 according to an embodiment.

The pixels may be arranged in the display area DA of the display apparatus 1. Each pixel may include sub-pixels configured to emit light having different colors, respectively. Light-emitting elements corresponding to the sub-pixels may be arranged in the display area DA. A circuit configured to provide electrical signals to the light-emitting elements arranged in the display area DA and transistors electrically connected to the light-emitting elements may be in the non-display area NDA near the display area DA. A gate driving circuit GDC may be arranged in each of a first non-display area NDA1 and a second non-display area NDA2 arranged at two sides of the display area DA. The gate driving circuit GDC may include drivers configured to provide electrical signals to gate electrodes of the transistors electrically connected to the light-emitting elements. Although FIG. 3 illustrates that the gate driving circuit GDC is arranged in each of the first non-display area NDA1 and the second non-display area NDA2, the disclosure is not limited thereto. In another embodiment, the gate driving circuit GDC may be arranged in any one of the first non-display area NDA1 and the second non-display area NDA2.

A data driving circuit DDC may be arranged in a third non-display area NDA3 and/or a fourth non-display area NDA4 connecting the first non-display area NDA1 and the second non-display area NDA2. In an embodiment, FIG. 3 illustrates that the data driving circuit DDC is arranged in the fourth non-display area NDA4. In another embodiment, the data driving circuit DDC may be arranged in each of the third non-display area NDA3 and the fourth non-display area NDA4.

Although FIG. 3 illustrates that the data driving circuit DDC is arranged in the fourth non-display area NDA4 of the display apparatus 1, the disclosure is not limited thereto. In another embodiment, the display apparatus 1 may further include a flexible circuit board (not shown) electrically connected to the display apparatus 1 through a terminal portion (not shown) arranged in the fourth non-display area NDA4, and the data driving circuit DDC may be disposed on the aforementioned flexible circuit board.

In some embodiments, an elongation rate of the non-display area NDA may be not more than an elongation rate of the display area DA. In an embodiment, the non-display area NDA may have different elongation rates according to areas. For example, although the first non-display area NDA1, the second non-display area NDA2, and the third non-display area NDA3 may have a substantially same elongation rate, an elongation rate of the fourth non-display area NDA4 may be less than the elongation rate of each of the first non-display area NDA1, the second non-display area NDA2, and the third non-display area NDA3.

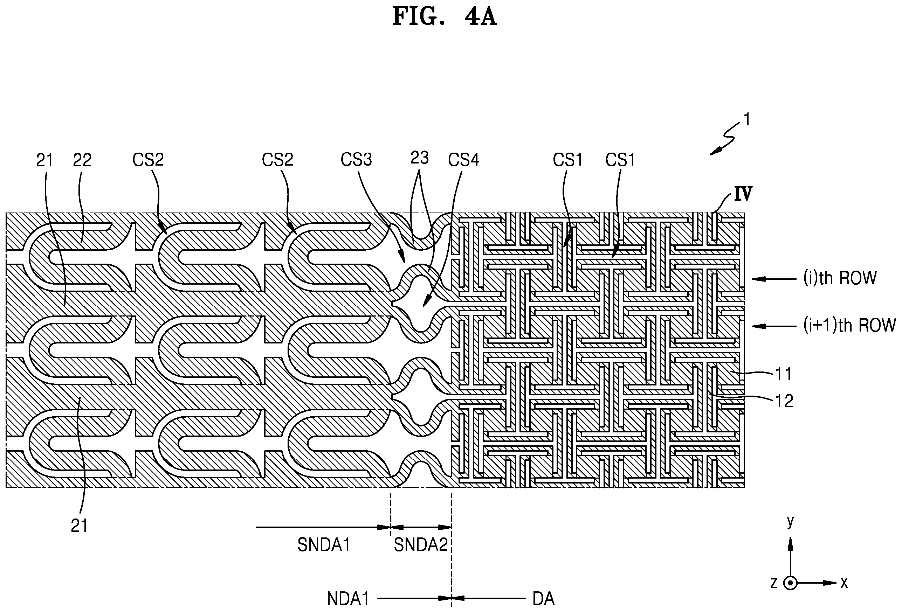

FIG. 4A is an enlarged plan view of a portion IV shown in FIG. 3 as a portion of the display apparatus 1 according to an embodiment.

Referring to FIG. 4A, the display apparatus 1 may include: first island portions 11 apart from one another in the first direction (e.g., the x direction or the - x direction) and the second direction (e.g., the y direction or the - y direction) in the display area DA; and first bridge portions 12 each connecting first island portions 11 adjacent to each other.

Each of the first island portions 11 may be connected to the first bridge portions 12. For example, each of the first island portions 11 may be connected to four first bridge portions 12. Two of the first bridge portions 12 may be arranged at two sides of the first island portion 11 in the first direction (e.g., the x direction or the - x direction), and another two of the first bridge portions 12 may be arranged at two sides of the first island portion 11 in the second direction (e.g., the y direction or the - y direction). In an embodiment, four first bridge portions 12 may be connected to four sides of a first island portion 11, respectively. Each of the four first bridge portions 12 may be adjacent to each of corners of the first island portion 11.

The first bridge portions 12 may be apart from each other by a first opening portion CS1 between the first bridge portions 12. In an embodiment, the first opening portions CS1 having a shape approximately like the letter "H" and the first opening portions CS1 having a shape approximately like the letter "I", where the shape like the letter "I" is obtained by rotating the aforementioned shape like the letter "H" by 90°, may be alternately and repeatedly arranged in the first direction (e.g., the x direction and the - x direction) and the second direction (e.g., the y direction or the - y direction). Two ends of each of the first bridge portions 12 may be arranged to the first island portions 11 adjacent to each other, respectively, and a side of each of the first bridge portions 12 may be apart from a side of the first island portions 11 adjacent to each other and/or a side of another first bridge portion 12 by the first opening CS1.

In the non-display area NDA, e.g., the first non-display area NDA1 shown in FIG. 4A, the display apparatus 1 may include second island portions 21 apart from one another and second bridge portions 22 each connecting second island portions 21 adjacent to each other.

Each of the second island portions 21 may extend in the first direction (e.g., the x direction or the - x direction). The second island portions 21 may be apart from one another in the second direction (e.g., the y direction or the - y direction) crossing the first direction (e.g., the x direction or the - x direction). Each of the second island portions 21 may include drivers of the gate driving circuit GDC (see FIG. 3) described with reference to FIG. 3.

The second bridge portion 22 may have a serpentine shape. A length of the second bridge portion 22 may be greater than a minimum distance between the second island portions 21 adjacent to each other in the second direction (e.g., the y direction or the - y direction). In an embodiment, the second bridge portion 22 may have a shape approximately like the Greek letter "Ω" being convex in the first direction (e.g., the x direction or the - x direction). The second bridge portions 22 may be arranged between the second island portions 21 adjacent to each other, and may be apart from each other.

The second bridge portions 22 between the second island portions 21 adjacent to each other may be apart from each other by a second opening CS2. Between the second island portions 21 adjacent to each other, the second openings CS2 and the second bridge portions 22 may be alternately arranged in the first direction (e.g., the x direction or the - x direction). The second openings CS2 may have the same shape. Two end portions of each of the second bridge portions 22 may be connected to the second island portions 21 adjacent to each other, and a side of each of the second bridge portions 22 may be apart from a side of the second island portions 21 adjacent to the second bridge portion 22 and/or a side of another second bridge portion 22.

Any one of the second island portions 21 arranged in the first non-display area NDA1 may correspond to the first island portions 11 in rows arranged in the display area DA. For example, any one of the second island portions 21 arranged in the first non-display area NDA1 may correspond to the first island portions 11 arranged in an (i)^{th} row and the first island portions 11 arranged in an (i+1)^{th} row (where i is a positive number). Although FIG. 4A illustrates that a second island portion 21 corresponds to two rows of the first island portions 11, the disclosure is not limited thereto. In another embodiment, any one of the second island portions 21 arranged in the first non-display area NDA1 may correspond to n rows of the first island portions 11 arranged in the display area DA (where n is a positive number of 3 or greater).

The non-display area NDA, e.g., the first non-display area NDA1, may include: a first sub-non-display area SNDA1 in which the second island portions 21 and the second bridge portions 22 are arranged; and a second sub-non-display area SNDA2 between the first sub-non-display area SNDA1 and the display area DA. Third bridge portions 23 to connect the display area DA and the first sub-non-display area SNDA1 may be arranged in the second sub-non-display area SNDA2. An end portion of the third bridge portion 23 may be connected to the second island portion 21 and/or the second bridge portion 22, and another end portion of the third bridge portion 23 may be connected to the first island portion 11 and/or the first bridge portion 12.

The third bridge portion 23 may have a serpentine shape. In an embodiment, a shape of the third bridge portion 23 may be different from the shapes of the first bridge portion 12 and the second bridge portion 22. In an embodiment, as shown in FIG. 4A, the third bridge portion 23 may have a shape approximately like the Greek letter "Ω" being convex in the second direction (e.g., the y direction or the - y direction). The third bridge portions 23 adjacent to each other and arranged in the second direction (e.g., the y direction or the - y direction) may have a symmetrical structure, e.g., one may be convex in the y direction, and another one may be convex in the - y direction. Third openings CS3 and fourth openings CS4 having different shapes may be repeatedly arranged between the third bridge portions 23. A width of the third bridge portion 23 may be different from a width of the first bridge portion 12 and a width of the second bridge portion 22. In an embodiment, the width of the third bridge portion 23 may be greater than the width of the first bridge portion 12 and less than the width of the second bridge portion 22.

FIG. 4A illustrates that the second island portion 21 and the second bridge portion 22 in the non-display area NDA, e.g., the first non-display area NDA1, have shapes different from the shapes of the first island portion 11 and the first bridge portion 12 in the display area DA. According to another embodiment, the second island portion 21 and the second bridge portion 22 in the non-display area NDA may have shapes identical to the shapes of the first island portion 11 and the first bridge portion 12 in the display area DA.

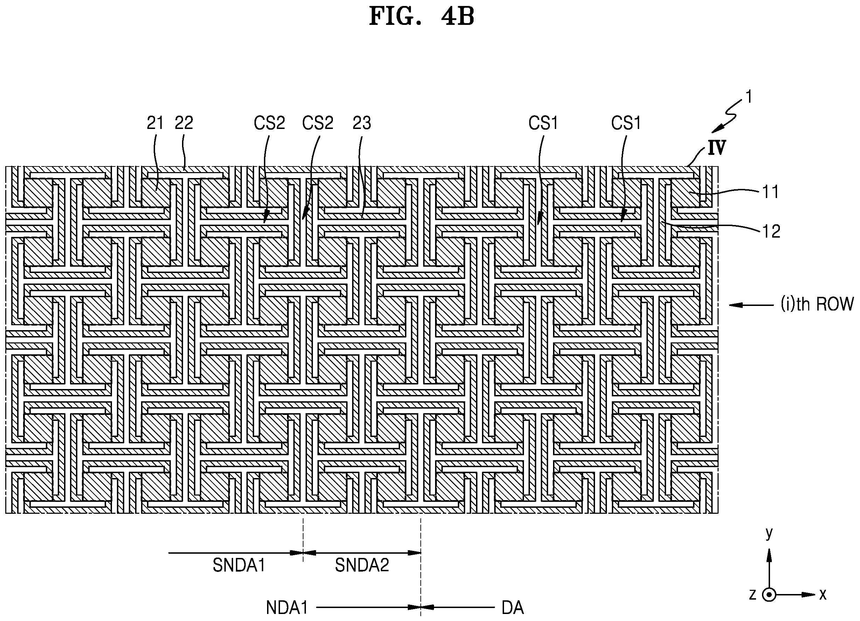

FIG. 4B is an enlarged plan view of the portion IV shown in FIG. 3 as a portion of the display apparatus 1 according to another embodiment.

Referring to FIG. 4B, the display apparatus 1 includes: the first island portions 11 apart from each other in the display area DA; and the first bridge portions 12 apart from each other by the first opening CS1 and each connecting the first island portions 11 adjacent to each other. A structure of the display area DA shown in FIG. 4B may be identical to a structure of the display area DA described above with reference to FIG. 4A.

The display apparatus 1 may include the second island portions 21 and the second bridge portions 22 arranged in the non-display area NDA, e.g., the first non-display area NDA1. In an embodiment, the second island portions 21 and the second bridge portions 22 may have shapes substantially identical to the shapes of the first island portions 11 and the first bridge portions 12.

The second island portions 21 may be apart from each other in the first direction (e.g., the x direction and the - x direction) and the second direction (e.g., the y direction and the - y direction) in the non-display area NDA, e.g., the first non-display area NDA1. Each of the second bridge portions 22 may connect the second island portions 21 adjacent to each other. The second bridge portions 22 may be apart from each other by the second opening CS2 between the second bridge portions 22.

The second opening CS2 may have a shape substantially identical to the shape of the first opening CS1. For example, the second openings CS2 having the shape approximately like the letter "H" and the second opening CS2 having the shape approximately like the letter "I" may be alternately and repeatedly arranged in the non-display area NDA, e.g., the first non-display area NDA1. Two end portions of each of the second bridge portions 22 may be connected to each of the second island portions 21 adjacent to the second bridge portion 22, and a side of each of the second bridge portion 22 may be apart from a side of the second island portion 21 adjacent to the second bridge portion 22 and/or a side of another second bridge portion 22 by the second opening CS2.

Each of the second island portions 21 may be connected to four second bridge portions 22. Each of the second island portions 21 may include drivers of the gate driving circuit GDC (see FIG. 3) described with reference to FIG. 3.

The second island portions 21 in any one row arranged in the first non-display area NDA1 may correspond to the first island portions 11 in any one row arranged in the display area DA. For example, the second island portions 21 arranged in the (i)^{th} row in the first direction (e.g., the x direction or the - x direction) in the first non-display area NDA1 may correspond to the first island portions 11 arranged in the same row, e.g., the (i)^{th} row, in the display area DA (where i is a positive number).

The display apparatus 1 may include the third bridge portions 23 arranged in the second sub-non-display area SNDA2 to connect the display area DA and the first sub-non-display area SNDA1. The non-display area NDA, e.g., the first non-display area NDA1, may include: the first sub-non-display area SNDA1 in which the second island portions 21 and the second bridge portions 22 are arranged; and the second sub-non-display area SNDA2 including the third bridge portions 23 and being between the first sub-non-display area SNDA1 and the display area DA. The third bridge portion 23 may be substantially identical to the first bridge portion 12 and the second bridge portion 22. For example, the width of the third bridge portion 23 may be identical to the width of the first bridge portion 12 and the width of the second bridge portion 22.

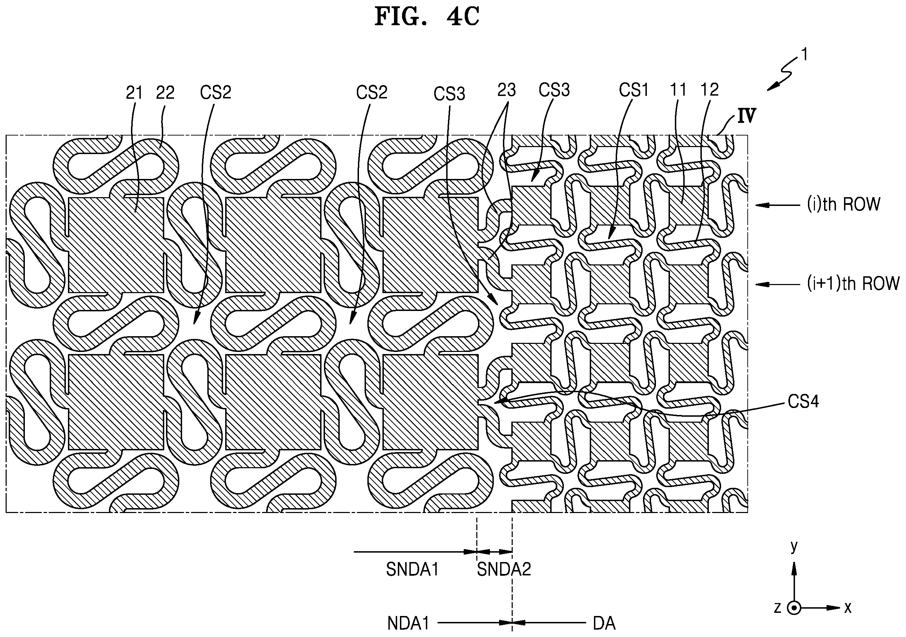

FIG. 4C is an enlarged plan view of the portion IV shown in FIG. 3 as a portion of the display apparatus 1 according to still another embodiment.

Referring to FIG. 4C, the display apparatus 1 may include the first island portions 11 apart from one another in the first direction (e.g., the x direction or the - x direction) and the second direction (e.g., the y direction and the - y direction) and the first bridge portions 12 connecting the first island portions 11 adjacent to each other.

The first bridge portions 12 may be arranged apart from each other by the first opening CS1 between the first bridge portions 12. The first bridge portion 12 may have a serpentine shape. For example, as shown in FIG. 4C, the first bridge portion 12 may have a shape approximately like the letter "S".

Each of the first island portions 11 may be connected to the first bridge portions 12. For example, each of the first island portions 11 may be connected to four first bridge portions 12. Two of the first bridge portions 12 may be arranged at two sides of the first island portion 11 in the first direction (e.g., the x direction or the - x direction), and another two of the first bridge portions 12 may be arranged at two sides of the first island portion 11 in the second direction (e.g., the y direction or the - y direction). Four first bridge portions 12 may be connected to four sides of the first island portion 11, respectively. Each of the four first bridge portions 12 may each be adjacent to each of corners of the first island portion 11.

In the non-display area NDA, e.g., the first non-display area NDA1 shown in FIG. 4C, the display apparatus 1 may include: the second island portions 21 apart from one another in the first direction (e.g., the x direction or the - x direction) and the second direction (e.g., the y direction and the - y direction) and the second bridge portions 22 each connecting second island portions 21 adjacent to each other.

The second bridge portions 22 may be apart from each other by the second opening CS2 between the second bridge portions 22. The second bridge portion 22 may have a serpentine shape. For example, as shown in FIG. 4C, the second bridge portion 22 may have a shape approximately like the letter "S". A size and/or a width of the second bridge portion 22 may be different from a size and/or a width of the first bridge portion 12. For example, the size and/or the width of the second bridge portion 22 may be greater than the size and/or the width of the first bridge portion 12. A radius of curvature of a rounded portion of the second bridge portion 22 may be different from a radius of curvature of a rounded portion of the first bridge portion 12. For example, the radius of curvature of the rounded portion of the second bridge portion 22 may be greater than the radius of curvature of the rounded portion of the first bridge portion 12.

Each of the second island portions 21 may be connected to second bridge portions 22. Each of the second island portions 21 may be connected to four second bridge portions 22. Two of the second bridge portions 22 may be arranged at two sides of the second island portion 21 in the first direction (e.g., the x direction or the - x direction), and another two of the second bridge portions 22 may be arranged at two sides of the second island portion 21 in the second direction (e.g., the y direction or the - y direction). In an embodiment, four second bridge portions 22 may be connected to four sides of the second island portion 21, respectively. Each of the second bridge portions 22 may be connected to a center portion of each side of the second island portion 21.

The second island portions 21 of any one row arranged in the first non-display area NDA1 may correspond to the first island portions 11 in the rows arranged in the display area DA. For example, the second island portions 21 in any one row arranged in the first non-display area NDA1 may correspond to the first island portions 11 arranged in the (i)^{th} row and the first island portions 11 arranged in the (i+1)^{th} row in the display area DA (where i is a positive number). In another embodiment, the second island portions 21 in any one row may correspond to the first island portions 11 in n rows (where n is a positive number of three or greater).

The non-display area NDA, e.g., the first non-display area NDA1, may include: the first sub-non-display area SNDA1 in which the second island portions 21 and the second bridge portions 22 are arranged; and the second sub-non-display area SNDA2 between the first sub-non-display area SNDA1 and the display area DA. The third bridge portions 23 to connect the display area DA and the first sub-non-display area SNDA1 may be arranged in the second sub-non-display area SNDA2. An end portion of the third bridge portion 23 may be connected to the second island portion 21, and another end portion of the third bridge portion 23 may be connected to the first island portion 11. For example, the end portion of the third bridge portion 23 may be connected to a center portion of a side of the second island portion 21, and the other end portion of the third bridge portion 23 may be connected to a center portion of a side of the first island portion 11.

The third bridge portion 23 may have a serpentine shape. In an embodiment, the shape of third bridge portion 23 may be different from the shapes of the first bridge portion 12 and the second bridge portion 22. A width of the third bridge portion 23 may be different from a width of the first bridge portion 12 and a width of the second bridge portion 22. The width of the third bridge portion 23 may be greater than the width of the first bridge portion 12 and less than the width of the second bridge portion 22. Third openings CS3 and fourth openings CS4 having different shapes may be alternately arranged between the third bridge portions 23 in the second direction (e.g., the y direction or the - y direction).

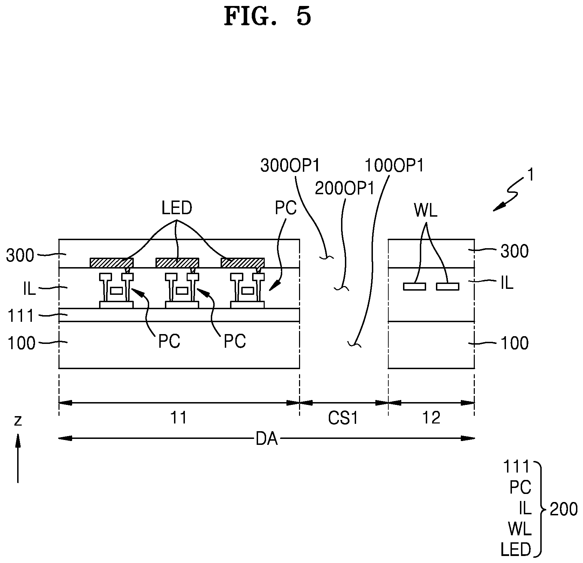

FIG. 5 is a cross-sectional view schematically illustrating the first island portion 11 and the first bridge portion 12 arranged in the display area DA of the display apparatus 1 according to an embodiment.

Referring to FIG. 5, the first island portion 11 and the first bridge portion 12 arranged in the display area DA may be arranged apart from each other with the first opening CS1 therebetween. The first island portion 11 may include light-emitting elements LED and a circuit configured to drive the light-emitting elements LED and electrically connected to the light-emitting elements LED, e.g., the pixel driving circuit unit PC, and the first bridge portion 12 may include wirings WL electrically connected to the pixel driving circuit units PC arranged in the first island portions 11 adjacent to each other, respectively.

In the first island portion 11, a buffer layer 111 including an inorganic insulating material may be disposed on the substrate 100, and the pixel driving circuit unit PC may be disposed on the buffer layer 111. An insulating layer IL including an inorganic insulator and/or an organic insulator may be disposed between the pixel driving circuit unit PC and the light-emitting elements LED. The light-emitting elements LED may be disposed on the insulating layer IL, and may be electrically connected to a corresponding pixel driving circuit unit PC. The light-emitting elements LED may emit light having different colors or the same color. In an embodiment, the light-emitting elements LED may be configured to emit red, green, and blue light, respectively. In some embodiments, the light-emitting elements LED may be configured to emit white light. In another embodiment, the light-emitting elements LED may be configured to emit red, green, blue, and white light, respectively.

The substrate 100 may include a polymer resin such as polyethersulfone, polyarylate, polyetherimide, polyethylene naphthalate, polyethylene terephthalate, polyphenylene sulfide, polyimide, polycarbonate, cellulose triacetate, and cellulose acetate propionate. In an embodiment, the substrate 100 may include a single layer including the aforementioned polymer resin. In another embodiment, the substrate 100 may have a multi-layer structure including: a base layer including the aforementioned polymer resin; and a barrier layer including an inorganic insulator. The substrate 100 including the polymer resin may be flexible, rollable, and bendable.

In an embodiment, FIG. 5 illustrates that three pixel driving circuit units PC are arranged in each of the first island portions 11 and three light-emitting elements LED are connected to each of the pixel driving circuit units PC, the disclosure is not limited thereto. In another embodiment, the numbers of the pixel driving circuit units PC and the light-emitting elements LED arranged in the first island portion 11 may be one, two, or at least four.

An encapsulation layer 300 may be disposed on the light-emitting elements LED and may protect the light-emitting elements LED from an external force and/or moisture. The encapsulation layer 300 may include an inorganic encapsulation layer and/or an organic encapsulation layer. In some embodiments, the encapsulation layer 300 may include a structure in which an inorganic encapsulation layer including an inorganic insulator, an organic encapsulation layer including an organic insulator, and an inorganic encapsulation layer including an inorganic insulator are stacked. In another embodiment, the encapsulation layer 300 may include an organic material such as a resin. In some embodiments, the encapsulation layer 300 may include urethane epoxy acrylate. The encapsulation layer 300 may include a photosensitive material, e.g., a material such as a photoresist.

In the first bridge portion 12, an insulating layer IL including an organic insulator may be disposed on the substrate 100. When the display apparatus 1 extends, unlike the first island portion 11, the first bridge portion 12 that is deformed to a relatively greater degree may not include a layer including an inorganic insulating material in which cracks easily occur.

In an embodiment, the substrate 100 corresponding to the first bridge portion 12 may have a stack structure identical to a stack structure of the substrate 100 corresponding to the first island portion 11. In an embodiment, the substrate 100 corresponding to the first bridge portion 12 and the substrate 100 corresponding to the first island portion 11 may include a polymer resin layer formed together in the same process. In another embodiment, the substrate 100 corresponding to the first bridge portion 12 may have a stack structure different from the stack structure of the substrate 100 corresponding to the first island portion 11. In some embodiments, the substrate 100 corresponding to the first island portion 11 may have a multi-layered structure including: a base layer including a polymer resin; and a barrier layer including an inorganic insulator, and the substrate 100 corresponding to the first bridge portion 12 may have a structure of a polymer resin layer, without a layer including an inorganic insulator.

As described above, the wirings WL of the first bridge portion 12 may include the signal lines (e.g., the gate line, the data line, and/or the like) configured to provide electrical signals or the voltage lines (e.g., the driving voltage line, the initialization voltage line, and/or the like) configured to provide voltages to the transistor included in the pixel driving circuit unit PC of the first island portion 11. In an embodiment, the encapsulation layer 300 may also be arranged in the first bridge portion 12. In another embodiment, the encapsulation layer 300 may not be arranged in the first bridge portion 12.

Referring to FIGS. 4A to 4C and FIG. 5, the substrate 100 corresponding to the first island portion 11 and the substrate 100 corresponding to the first bridge portion 12 may be connected to each other. In other words, the plan views shown above in FIGS. 4A to 4C may be substantially identical to the plan view of the substrate 100 shown in FIG. 5. In other words, the substrate 100 may include an area corresponding to the first island portion 11, an area corresponding to the first bridge portion 12, and an opening 100OP1 having a shape identical to a shape of a first opening CS1.

Similarly, the encapsulation layer 300 corresponding to the first island portion 11 and the encapsulation layer 300 corresponding to the first bridge portion 12 may be connected to each other. For example, the plan views shown above in FIGS. 4A to 4C may be substantially identical to the plan view of the encapsulation layer 300. In other words, the encapsulation layer 300 may include an area corresponding to the first island portion 11, an area corresponding to the first bridge portion 12, and an opening 300OP1 having a shape identical to a shape of the first opening CS1.

A circuit-light-emitting element layer 200 between the substrate 100 and the encapsulation layer 300 may include the buffer layer 111, the pixel driving circuit unit PC, the wirings WL, the insulating layer IL and the light-emitting element LED. Like the substrate 100, the plan views shown above in FIGS. 4A to 4C may be substantially identical to a plan view of the circuit-light-emitting element layer 200. In other words, the circuit-light-emitting element layer 200 may include an opening 200OP1 having a shape identical to the shape of the first opening CS1.

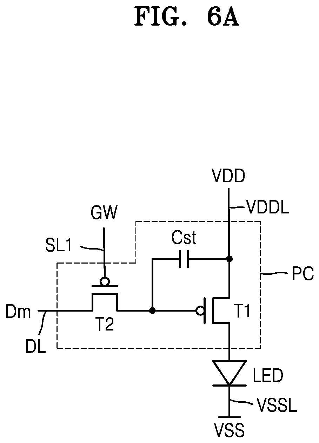

FIGS. 6A to 6C are each equivalent circuit diagrams of a subpixel of the display apparatus 1 according to an embodiment.

Referring to FIG. 6A, the light-emitting element LED corresponding to the subpixel is electrically connected to the pixel driving circuit unit PC, and the pixel driving circuit unit PC may include a first transistor T1, a second transistor T2, and a storage capacitor Cst. The pixel driving circuit unit PC may be electrically connected to signal lines and voltage lines. The signal lines may include a gate line, e.g., a first scan line SL1, and a data line DL, and the voltage lines may include a first voltage line VDDL.

The second transistor T2 may be electrically connected to the first scan line SL1 and the data line DL. The first scan line SL1 may provide a first scan signal GW to a gate electrode of the second transistor T2. The second transistor T2 may be configured to deliver a data signal Dm input from the data line DL to the first transistor T1, in response to the first scan signal GW input from the first scan line SL1.

The storage capacitor Cst may be electrically connected to the second transistor T2 and the first voltage line VDDL, and may be configured to store a voltage corresponding to a difference between a voltage delivered from the second transistor T2 and a first power voltage VDD provided from the first voltage line VDDL.

The first transistor T1, which is a driving transistor, may be configured to control a driving current flowing through the light-emitting element LED. The first transistor T1 may be connected to the first voltage line VDDL and the storage capacitor Cst. The first transistor T1 may be configured to control a driving current flowing from the first voltage line VDDL through the light-emitting element LED to correspond to a value of the voltage stored in the storage capacitor Cst. The light-emitting element LED may be configured to emit light of certain luminance in response to the driving current. A first electrode of the light-emitting element LED may be electrically connected to the first transistor T1, and a second electrode of the light-emitting element LED may be electrically connected to a second voltage line VSSL configured to provide a second power voltage VSS.

Although FIG. 6A illustrates that the pixel driving circuit unit PC includes two transistors and one storage capacitor, in another embodiment, the pixel driving circuit unit PC may include three or more transistors.

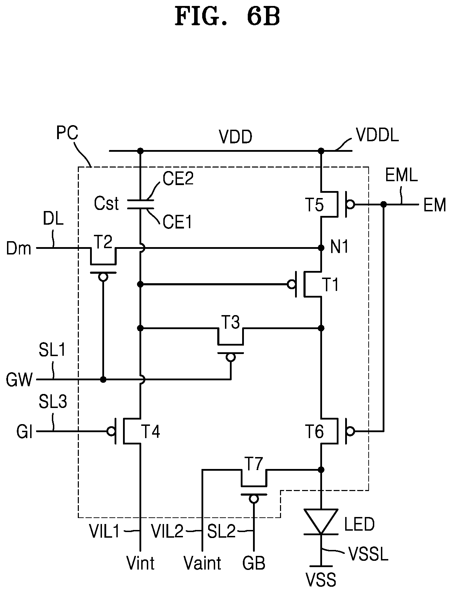

Referring to FIG. 6B, the pixel driving circuit unit PC may include a first transistor T1, a second transistor T2, a third transistor T3, a fourth transistor T4, a fifth transistor T5, a sixth transistor T6, a seventh transistor T7, and a storage capacitor Cst.

The pixel driving circuit unit PC may be electrically connected to the signal lines and the voltage lines. The signal lines may include gate lines, e.g., a first scan line SL1, a second scan line SL2, a third scan line SL3, and a light emission control line EML, and a data line DL. The voltage lines may include a first initialization voltage line VIL1, a second initialization voltage line VIL2, and the first voltage line VDDL.

The first voltage line VDDL may be configured to drive the first power voltage VDD to the first transistor T1. The first initialization voltage line VIL1 may be configured to drive a first initialization voltage Vint, which initializes the first transistor T1, to the pixel driving circuit unit PC. The second initialization voltage line VIL2 may be configured to drive a second initialization voltage Vaint, which initializes the first electrode of the light-emitting element LED, to the pixel driving circuit unit PC.

The first transistor T1 may be electrically connected to the first voltage line VDDL via the fifth transistor T5, and may be electrically connected to the light-emitting element LED via the sixth transistor T6. The first transistor T1 is configured to function as the driving transistor, receive the data signal Dm in response to a switching operation of the second transistor T2, and provide the driving current to the light-emitting element LED.

The second transistor T2, which is a data write transistor, is electrically connected to the first scan line SL1 and the data line DL. The second transistor T2 is electrically connected to the first voltage line VDDL via the fifth transistor T5. The second transistor T2 is turned on in response to the first scan signal GW delivered through the first scan line SL1 and performs a switching operation of delivering the data signal Dm, which is delivered from the data line DL to a first node N1.

The third transistor T3 is electrically connected to the first scan line SL1 and is also electrically connected to the light-emitting element LED via the sixth transistor T6. The third transistor T3 may be turned on in response to the first scan signal GW delivered through the first scan line SL1 and may have the first transistor T1 diode-connected.

The fourth transistor T4, which is a first initialization transistor, is electrically connected to a third scan line SL3 and the first initialization voltage line VIL1. The fourth transistor T4 is turned on in response to a third scan signal GI delivered through the third scan line SL3, delivers the first initialization voltage Vint from the first initialization voltage line VIL1 to the gate electrode of the first transistor T1, and initializes a voltage of the gate electrode of the first transistor T1. The third scan signal GI may correspond to a first scan signal of another pixel driving circuit unit PC arranged in a previous row before a row including a corresponding pixel driving circuit unit PC.

The fifth transistor T5 may include an operation control transistor, and the sixth transistor T6 may include a light emission control transistor. The fifth transistor T5 and the sixth transistor T6 are electrically connected to the light emission control line EML, and are simultaneously turned on in response to a light emission control signal EM delivered through the light emission control line EML, and form a current path such that the driving current may flow in a direction from the first voltage line VDDL toward the light-emitting element LED.

The seventh transistor T7, which is a second initialization transistor, may be electrically connected to the second scan line SL2, the second initialization voltage line VIL2, and the sixth transistor T6. The seventh transistor T7 may be turned on in response to a second scan signal GB received through the second scan line SL2, and may initialize a first electrode of the light-emitting element LED by delivering the second initialization voltage Vaint from the second initialization voltage line VIL2 to the first electrode of the light-emitting element LED.

The storage capacitor Cst may include the first electrode CE1 and the second electrode CE2. The first electrode CE1 may be electrically connected to the gate electrode of the first transistor T1, and the second electrode CE2 may be electrically connected to the first voltage line VDDL. The storage capacitor Cst may be configured to maintain a voltage applied to the gate electrode of the first transistor T1 by storing and maintaining a voltage corresponding to a difference between voltages at two ends of the gate electrode of each of the first transistor T1 and the first voltage line VDDL.

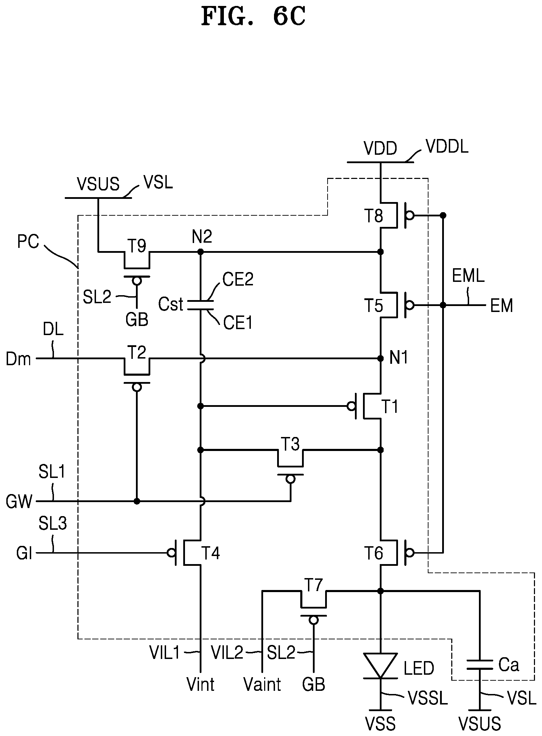

Referring to FIG. 6C, the pixel driving circuit unit PC may include a first transistor T1, a second transistor T2, a third transistor T3, a fourth transistor T4, a fifth transistor T5, a sixth transistor T6, a seventh transistor T7, an eighth transistor T8, a ninth transistor T9, a storage capacitor Cst, and an auxiliary capacitor Ca.

The pixel driving circuit unit PC may be electrically connected to the signal lines and the voltage lines. The signal lines may include the gate lines, e.g., the first scan line SL1, the second scan line SL2, the third scan line SL3, and the light emission control line EML, and the data line DL. The voltage lines may include a first initialization voltage line VIL1, a second initialization voltage line VIL2, a sustenance voltage line VSL, and the first voltage line VDDL.

The first voltage line VDDL may be configured to drive the first power voltage VDD to the first transistor T1. The first initialization voltage line VIL1 may be configured to drive the first initialization voltage Vint, which initializes the first transistor T1, to the pixel driving circuit unit PC. The second initialization voltage line VIL2 may be configured to drive a second initialization voltage Vaint, which initializes the first electrode of the light-emitting element LED, to the pixel driving circuit unit PC. The sustenance voltage line VSL may be configured to provide a sustenance voltage VSUS to a second node N2, e.g., the second electrode CE2 of the storage capacitor Cst, in an initialization section and a data write section.

The first transistor T1 may be electrically connected to the first voltage line VDDL via the fifth transistor T5 and the eighth transistor T8, and may be electrically connected to the light-emitting element LED via the sixth transistor T6. The first transistor T1 may be configured to function as the driving transistor, receive the data signal Dm in response to a switching operation of the second transistor T2, and provide the driving current to the light-emitting element LED.

The second transistor T2 is electrically connected to the first scan line SL1 and the data line DL, and is also electrically connected to the first voltage line VDDL via the fifth transistor T5 and the eighth transistor T8. The second transistor T2 is turned on in response to the first scan signal GW delivered from the first scan line SL1 and performs a switching operation of delivering the data signal Dm, which is delivered from the data line DL, to the first node N1.

The third transistor T3 is electrically connected to the first scan line SL1 and is also electrically connected to the light-emitting element LED via the sixth transistor T6. The third transistor T3 may be configured to compensate for a threshold voltage of the first transistor T1 by being turned on in response to the first scan signal GW, which is delivered through the first scan line SL1, and having the first transistor T1 diode-connected.

The fourth transistor T4 is electrically connected to the third scan line SL3 and the first initialization voltage line VIL1, is turned on in response in the third scan signal GI delivered through the third scan line SL3 and delivers the first initialization voltage Vint from the first initialization voltage line VIL1 to a gate electrode of the first transistor T1, to thereby initialize a voltage of the gate electrode of the first transistor T1. The third scan signal GI may correspond to the first scan signal of another pixel driving circuit unit PC arranged in the previous row before the row including the corresponding pixel driving circuit unit PC.

The fifth transistor T5, the sixth transistor T6, and the eighth transistor T8 are electrically connected to the light emission control line EML, are simultaneously turned on in response to the light emission control signal EM delivered through the light emission control line EML, and form a current path such that the driving current may flow from the first voltage line VDDL toward the light-emitting element LED.

The seventh transistor T7, which is the second initialization transistor, may be electrically connected to the second scan line SL2, the second initialization voltage line VIL2, and the sixth transistor T6. The seventh transistor T7 is turned on in response to the second scan signal GB delivered through the second scan line SL2, delivers the second initialization voltage Vaint from the second initialization voltage line VIL2 to the first electrode of the light-emitting element LED, and initializes the first electrode of the light-emitting element LED.

The ninth transistor T9 may be electrically connected to the second scan line SL2, the second electrode CE2 of the storage capacitor Cst, and the sustenance voltage line VSL. The ninth transistor T9 may be turned on in response to the second scan signal GB delivered through the second scan line SL2, and may be configured to deliver the sustenance voltage VSUS to the second node N2, e.g., the second electrode CE2 of the storage capacitor Cst, in the initialization section and the data write section.

The eighth transistor T8 and the ninth transistor T9 may each be electrically connected to the second node N2, e.g., the second electrode CE2 of the storage capacitor Cst. In some embodiments, in the initialization section and the data write section, the eighth transistor T8 may be turned off and the ninth transistor T9 may be turned on; and in a light emission section, the eighth transistor T8 may be turned on and the ninth transistor T9 may be turned off. In the initialization section and the data write section, the second node N2, to which the sustenance voltage VSUS is delivered, may be configured to improve long range uniformity ("LRU") of the display apparatus 1 according to a voltage drop of the first voltage line VDDL.

The storage capacitor Cst may include the first electrode CE1 and the second electrode CE2. The first electrode CE1 is electrically connected to the gate electrode of the first transistor T1, and the second electrode CE2 is electrically connected to the eighth transistor T8 and the ninth transistor T9.

The auxiliary capacitor Ca may be electrically connected to the sixth transistor T6, the sustenance voltage line VSL, and the first electrode of the light-emitting element LED. The auxiliary capacitor Ca may be configured to store and maintain a voltage corresponding to a difference between voltages of the first electrode of the light-emitting element LED and the sustenance voltage line VSL while the seventh transistor T7 and the ninth transistor T9 are turned on, to thereby prevent increase in black luminance when the sixth transistor T6 is off.

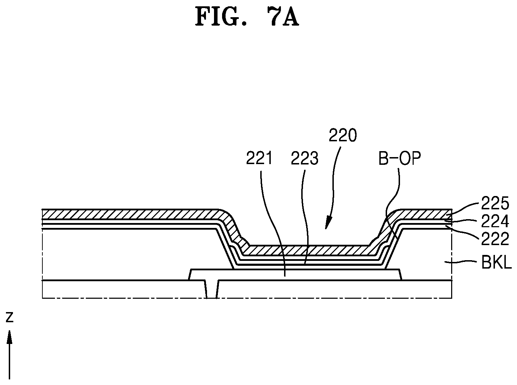

FIG. 7A is a cross-sectional view schematically illustrating the light-emitting element LED of the display apparatus 1 according to an embodiment.

Referring to FIG. 7A, the light-emitting element LED according to an embodiment may include an organic light-emitting diode 220 including an organic material. The organic light-emitting diode 220 may include a first electrode 221 disposed on an insulating layer, a second electrode 225 facing the first electrode 221, and a light emission layer 223 between the first electrode 221 and the second electrode 225. A first function layer 222 may be disposed between the first electrode 221 and the light emission layer 223, and a second function layer 224 may be disposed between the light emission layer 223 and the second electrode 225.

An edge of the first electrode 221 may be covered with a bank layer BKL including an insulator. The bank layer BKL may define an opening B-OP overlapping a center portion of the first electrode 221 in a plan view.

The first electrode 221 may include a conductive oxide such as indium tin oxide (ITO), indium zinc oxide (IZO), zinc oxide (ZnO), indium oxide (In₂O₃), indium gallium oxide (IGO), or aluminum zinc oxide (AZO). In another embodiment, the first electrode 221 may include a reflective layer including silver (Ag), magnesium (Mg), aluminum (Al), platinum (Pt), palladium (Pd), gold (Au), nickel (Ni), neodymium (Nd), iridium (Ir), chromium (Cr), or compounds thereof. In another embodiment, the first electrode 221 may further include a layer including ITO, IZO, ZnO, AZO, or In₂O₃ under/on the aforementioned reflective layer.

The light emission layer 223 may include a high-molecular or low-molecular organic material emitting light of certain colors. The first function layer 222 may include a hole transport layer ("HTL") and/or a hole injection layer ("HIL"). The second function layer 224 may include an electron transport layer ("ETL") and/or an electron injection layer ("EIL").

The second electrode 225 may include a conductive material having a small work function. In an embodiment, for example, the second electrode 225 may include a (semi) transparent layer including Ag, Mg, Al, Pt, Pd, Au, Ni, Nd, Ir, Cr, Li, Ca, or alloys thereof. Alternatively, the second electrode 225 may further include a layer including ITO, IZO, ZnO, AZO, or In₂O₃ on the (semi) transparent layer including the aforementioned materials.

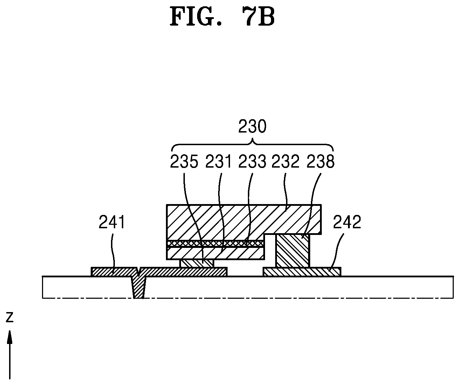

FIG. 7B is a cross-sectional view schematically illustrating the light-emitting element LED of the display apparatus 1 according to an embodiment.

Referring to FIG. 7B, the light-emitting element according to an embodiment may include an inorganic light-emitting diode 230 including an inorganic material. The inorganic light-emitting diode 230 may include a first semiconductor layer 231, a second semiconductor layer 232, an intermediate layer 233 between the first semiconductor layer 231 and the second semiconductor layer 232, a first electrode 235 electrically connected to the first semiconductor layer 231, and a second electrode 238 electrically connected to the second semiconductor layer 232. The first electrode 235 and the second electrode 238 of the inorganic light-emitting diode 230 may be electrically connected to a first electrode pad 241 and a second electrode pad 242 disposed in the same layer, respectively.

In some embodiments, the first semiconductor layer 231 may include a p-type semiconductor layer. The p-type semiconductor layer may be selected from among semiconductor materials having a composition formula of InₓAl_{y}Ga_{1-x-y}N (0≤x≤1, 0≤y≤1, 0≤x+y≤1), e.g., GaN, AlN, AlGaN, InGaN, InN, InAlGaN, AlInN, and may be doped with a p-type dopant such as Mg, Zn, Ca, Sr, Ba, and the like.

The second semiconductor layer 232 may include, for example, an n-type semiconductor layer. The n-type semiconductor layer may be selected from among semiconductor materials having a composition formula of InₓAl_{y}Ga_{1-x-y}N (0≤x≤1, 0≤y≤1, 0≤x+y≤1), e.g., GaN, AlN, AlGaN, InGaN, InN, InAlGaN, AlInN, and may be doped with a n-type dopant such as Si, Ge, Sn, and the like.

An intermediate layer 233, which is an area in which electrons and holes are recombined, transitions to a lower energy level as the electrons and holes are recombined, and may generate light having a corresponding wavelength. The intermediate layer 233 may be formed to include a semiconductor material having a composition formula such as InₓAl_{y}Ga_{1-x-y}N (0≤x≤1, 0≤y≤1, 0≤x+y≤1), and may be formed into a single quantum well structure or multi quantum well ("MQW") structure. In addition, the intermediate layer 233 may include a quantum wire structure or a quantum dot structure.

Although FIG. 7B illustrates that the first semiconductor layer 231 includes a p-type semiconductor layer and the second semiconductor layer 232 includes a n-type semiconductor layer, the disclosure is not limited thereto. In another embodiment, the first semiconductor layer 231 may include a n-type semiconductor layer and the second semiconductor layer 232 may include a p-type semiconductor layer.

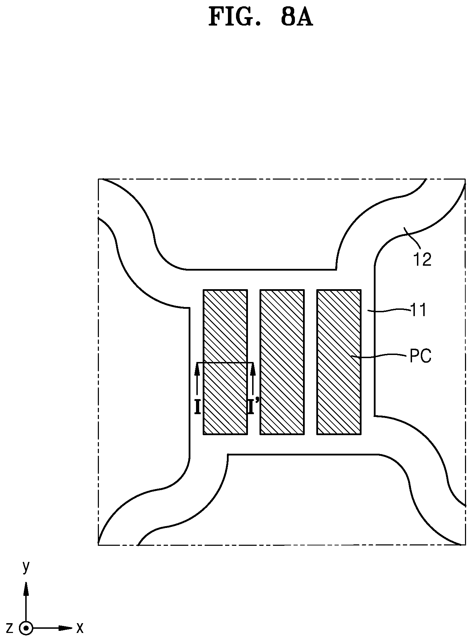

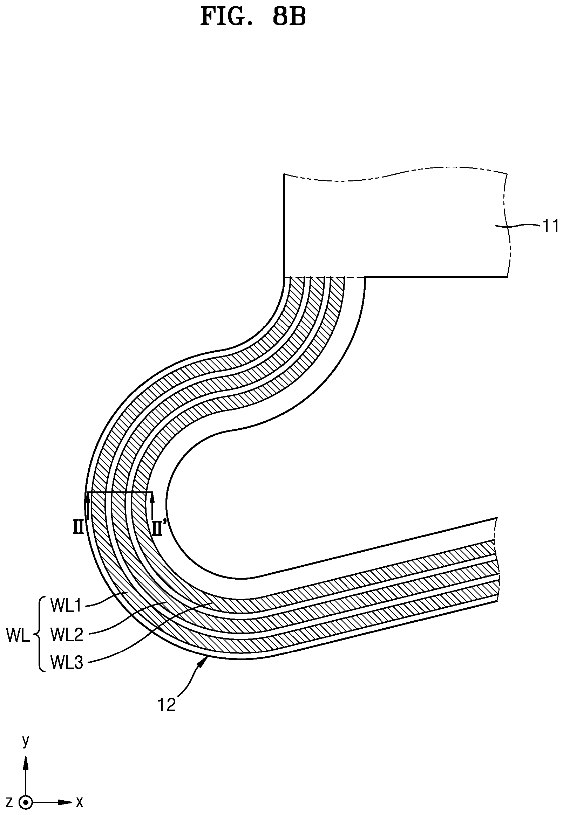

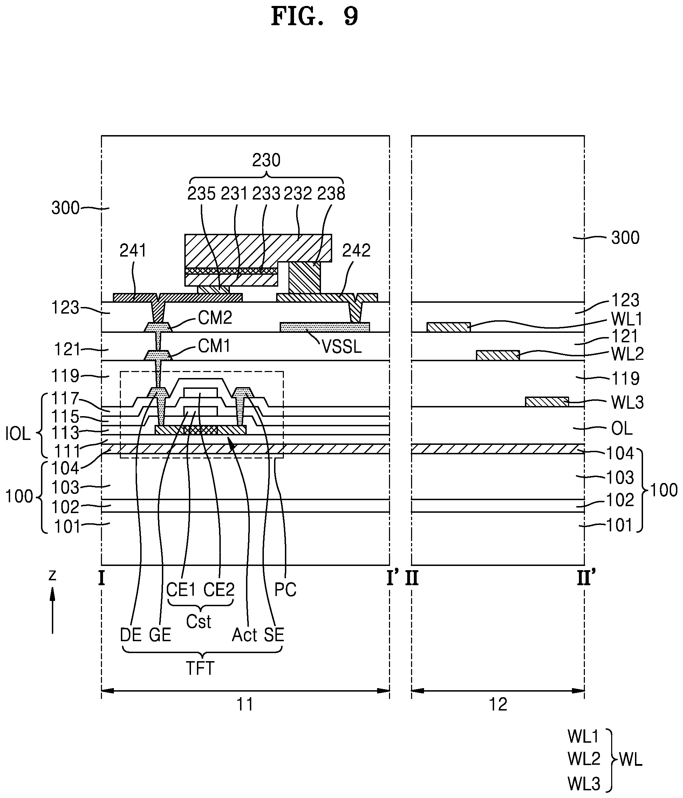

FIG. 8A is a plan view illustrating an enlarged image of the first island portion 11 of the display apparatus 1 according to an embodiment, and FIG. 8B is a plan view illustrating an arrangement of the wirings WL in the first bridge portion 12 of the display apparatus 1 according to an embodiment. In addition, FIG. 9 illustrates a cross-section taken along line I-I' shown in FIG. 8A and a cross-section taken along line II-II' shown in FIG. 8B.

Referring to FIG. 8A, the first island portion 11 arranged in the display area DA may include light-emitting elements and the pixel driving circuit unit PC electrically connected to the light-emitting elements. As described above, the pixel driving circuit unit PC may include transistors and at least one capacitor. Although FIG. 8A illustrates that three pixel driving circuit units PC are arranged in the first island portion 11, the disclosure is not limited thereto. In other embodiments, the numbers of the pixel driving circuit units PC and the light-emitting elements arranged in the first island portion 11 may be one, two, or four or more.

Referring to FIG. 9, the substrate 100 corresponding to the first island portion 11 may include a first base layer 101, a first barrier layer 102, a second base layer 103, and a second barrier layer 104. The first base layer 101 and the second base layer 103 may each include a polymer resin, e.g., polyethersulfone, polyarylate, polyetherimide, polyethylene naphthalate, polyethylene terephthalate, polyphenylene sulfide, polyimide, polycarbonate, cellulose triacetate, and cellulose acetate propionate. The first barrier layer 102 and the second barrier layer 104 may each include an inorganic insulating material such as silicon oxide, silicon nitride, and silicon oxynitride.

The buffer layer 111 may be disposed on the substrate 100, and the pixel driving circuit unit PC may be disposed on the buffer layer 111. The buffer layer 111 may include an inorganic insulating material such as silicon oxide, silicon nitride, and silicon oxynitride.

A thin-film transistor TFT may include a semiconductor layer Act, a gate electrode GE, a source electrode SE, and a drain electrode DE. Although FIG. 9 illustrates a top-gate type thin-film transistor in which the gate electrode GE is disposed on the semiconductor layer Act with a gate insulating layer 113 therebetween, according to another embodiment, the thin-film transistor TFT may include a bottom-gate type thin-film transistor.

The semiconductor layer Act may include polysilicon. Alternatively, the semiconductor layer Act may include amorphous silicon, an oxide semiconductor, an organic semiconductor, and/or the like. The gate electrode GE may include a low-resistance metal material. The gate electrode GE may include a conductive material including molybdenum (Mo), aluminum (Al), copper (Cu), titanium (Ti), and/or the like, and may include multiple layers or a single layer including the aforementioned materials.

The gate insulating layer 113 between the semiconductor layer Act and the gate electrode GE may include an inorganic insulating material such as silicon oxide, silicon nitride, silicon oxynitride, aluminum oxide, and titanium oxide. The gate insulating layer 113 may include a single layer or multiple layers including the aforementioned materials.

The source electrode SE and the drain electrode DE may be on the same layer, e.g. a second interlayer-insulating layer 117, and may include the same material. The source electrode SE and the drain electrode DE may each include a conductive material, and may each include multiple layers or a single layer. The second interlayer-insulating layer 117 may include an inorganic insulating material such as silicon oxide, silicon nitride, silicon oxynitride, aluminum oxide, titanium oxide, and may include a single layer or multiple layers including the aforementioned materials.

The storage capacitor Cst may include the first electrode CE1 and the second electrode CE2 overlapping each other with a first interlayer-insulating layer 115 therebetween in a plan view. The storage capacitor Cst may overlap the thin-film transistor TFT in a plan view. Regarding this, FIG. 9 illustrates that the gate electrode GE of the thin-film transistor TFT is the first electrode CE1 of the storage capacitor Cst. In another embodiment, the storage capacitor Cst may not overlap the thin-film transistor TFT in a plan view. The storage capacitor Cst may be covered with a second interlayer-insulating layer 117. The second electrode CE2 of the storage capacitor Cst may include a conductive material, and may include multiple layers or a single layer. The first interlayer-insulating layer 115 may be disposed between the gate insulating layer 113 and the second interlayer-insulating layer 117. The first interlayer-insulating layer 115 may include an inorganic insulator such as silicon oxide, silicon nitride, silicon oxynitride, aluminum oxide, and titanium oxide, and may include a single layer or multiple layers including the aforementioned materials.

An inorganic insulator layer IOL on the substrate 100 may include, for example, the buffer layer 111, the gate insulating layer 113, the first interlayer-insulating layer 115, and the second interlayer-insulating layer 117.

A first organic insulating layer 119 may be disposed on the second interlayer-insulating layer 117, and a second organic insulating layer 121 may be disposed on the first organic insulating layer 119. The first organic insulating layer 119 and the second organic insulating layer 121 may each include an organic insulator such as polyimide.

The second voltage line VSSL may be disposed on the second organic insulating layer 121, and a third organic insulating layer 123 may be disposed on the second organic insulating layer 121 and the second voltage line VSSL. The third organic insulating layer 123 may include an organic insulator such as polyimide. The second voltage line VSSL may include a conductive material, and may include multiple layers or a single layer.

The first electrode pad 241 and the second electrode pad 242 may be disposed on the third organic insulating layer 123. The first electrode pad 241 may be electrically connected to the thin-film transistor TFT through a first connection electrode CM1 between the first organic insulating layer 119 and the second organic insulating layer 121 and a second connection electrode CM2 between the second organic insulating layer 121 and the third organic insulating layer 123. The inorganic light-emitting diode 230 on the first electrode pad 241 and the second electrode pad 242 is as described above with reference to FIG. 7B. A light-emitting diode, e.g., the inorganic light-emitting diode 230 may be protected by the encapsulation layer 300, and the encapsulation layer 300 may include an inorganic encapsulation layer and/or an organic encapsulation layer, or may include an organic material such as a resin. Although FIG. 9 illustrates that the light-emitting diode is the inorganic light-emitting diode 230 described with reference to FIG. 7B, in another embodiment, the light-emitting diode may include the organic light-emitting diode 220 described above with reference to FIG. 7A.

Referring to FIG. 8B, the first bridge portion 12 may include wirings WL electrically connected to the pixel driving circuit units PC arranged in the first island portions 11 adjacent to one another, respectively. As described above, the wirings WL may include signal lines (e.g., the gate line, the data line) or voltage lines (e.g., the driving voltage line, the initialization voltage line) configured to provide electrical signals to the transistors included in the pixel driving circuit units PC of the first island portion 11. Although FIG. 8B illustrates that the wirings WL, e.g., a first wiring WL1, a second wiring WL2, and a third wiring WL3 are disposed in the first bridge portion 12, the disclosure is not limited thereto. In another embodiments, only one wiring WL may be disposed in the first bridge portion 12.

Referring to FIG. 9, according to an embodiment, the substrate 100 corresponding to the first bridge portion 12 may have a stack structure identical to a stack structure of the substrate 100 corresponding to the first island portion 11. In an embodiment, the substrate 100 corresponding to the first bridge portion 12 may include the first base layer 101, the first barrier layer 102, the second base layer 103, and the second barrier layer 104. In another embodiment, the substrate 100 corresponding to the first bridge portion 12 may have a stack structure different from the stack structure of the substrate 100 corresponding to the first island portion 11. The substrate 100 corresponding to the first bridge portion 12 may have a structure including the first base layer 101 and the second base layer 103.

The inorganic insulator layer IOL may not be disposed on the substrate 100, and an insulating layer OL, the first organic insulating layer 119, and the second organic insulating layer 121 may be disposed on the substrate 100. The insulating layer OL may include an organic insulator such as polyimide. In an embodiment, the insulating layer OL may have a thickness corresponding to a thickness of the inorganic insulator layer IOL. In some embodiments, the insulating layer OL may also be omitted.

The wirings WL, e.g., the first wiring WL1, the second wiring WL2, and the third wiring WL3 may be disposed in different layers from each other but may be electrically connected to the same pixel driving circuit unit PC. For example, the first wiring WL1 may be disposed between the second organic insulating layer 121 and the third organic insulating layer 123, the second wiring WL2 may be disposed between the first organic insulating layer 119 and the second organic insulating layer 121, and the third wiring WL3 may be disposed between the insulating layer OL and the first organic insulating layer 119. However, the disclosure is not limited thereto, and in other embodiments, at least some of the first wiring WL1, the second wiring WL2, and the third wiring WL3 may be disposed on the same layer.

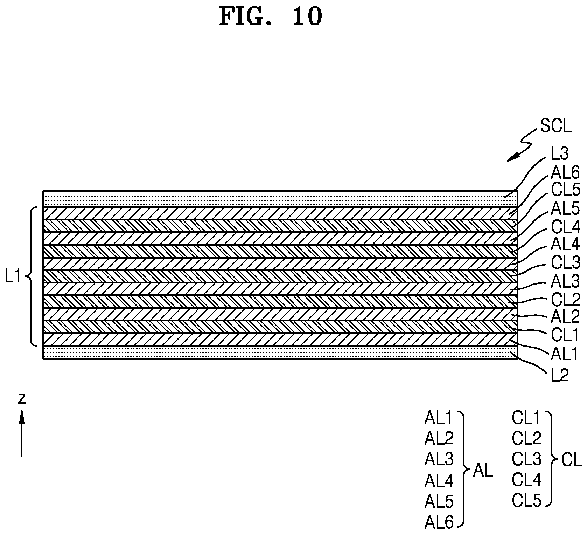

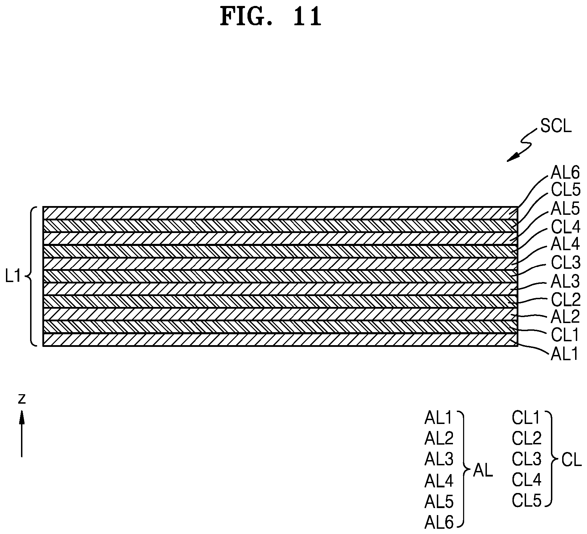

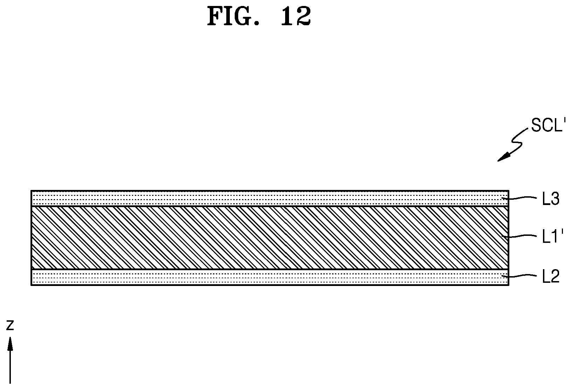

FIGS. 10 and 11 are cross-sectional views of the conductive layer SCL forming a wiring or a connection electrode of the display apparatus according to an embodiment. FIG. 12 is a cross-sectional view of the conductive layer SCL' according to a comparative example.

Referring to FIGS. 10 and 11, the conductive layer SCL may include a first layer L1. In an embodiment, the first layer L1 may have a structure including sub layers. The sub layers may include a first sub layer AL and a second sub layer CL.

The first sub layer AL may include an alloy layer. The first sub layer AL may include an alloy of aluminum (AI) and a rare-earth element. The first sub layer AL may include an amorphous alloy layer. The amorphous alloy may not include a grain-boundary. The amorphous alloy may have a high elastic strain limit. Among amorphous alloys, a fully amorphous alloy may undergo elastic deformation without plastic deformation. In the present specification, the amorphous alloy may include a case in which the alloy is fully amorphous and a case in which a nanocrystalline phase having a crystal size of only several nanometers exists in a dispersed state in an amorphous phase.

An atomic radius of the rare-earth element may be greater than an atomic radius of aluminum (AI). A ratio of a difference between the atomic radius of aluminum and the atomic radius of the rare-earth element to the atomic radius of aluminum may be about 25 % or greater. When the ratio of the difference to the atomic radius of Al is about 25 % or greater, crystallization due to regular alignment of atomics may be interrupted. An electronegativity of the rare-earth element may be less than an electronegativity of aluminum. The electronegativity of the rare-earth element may be about 1.0 or greater but not more than about 1.2. In an embodiment, the rare-earth element may include at least one of yttrium (Y), samarium (Sm), cerium (Ce), and lanthanum (La). Such rare-earth elements may have excellent ability of forming an amorphous material.

In an embodiment, the first sub layer AL may include a binary alloy having a composition formula of AlₐM_{b}. Here, M may include at least one rare-earth element selected from among yttrium (Y), samarium (Sm), cerium (Ce), and lanthanum (La). a and b each indicate the content (at%) of each element with reference to the total atomic weight of the first sub layer AL, and the sum of a and b may be 100. In an embodiment, a may be at least about 90 but not more than about 96, and b may be at least about 4 but not more than about 10. In other words, with reference to the total atomic weight of the first sub layer AL, the content of aluminum (AI) may be at least about 90 atomic percentages (at%) but not more than about 96 at%, and the content of the rare-earth element M may be least about 4 at% but not more than about 10 at%. When aluminum and the rare-earth element M included in the first sub layer AL satisfy the aforementioned range, the first sub layer AL may include an amorphous alloy layer having an extraordinary resistivity. When the content of aluminum is less than about 90 at%, the resistivity of the first sub layer AL may increase. When the content of aluminum is greater than about 96 at%, the first sub layer AL may not be formed into an amorphous alloy layer. When the content of the first sub layer AL is less than about 4 at%, the first sub layer AL may not be formed into an amorphous alloy layer. When the content of the rare-earth element M is greater than about 10 at%, the resistivity of the first sub layer AL may increase. In an embodiment, the first sub layer AL may include an alloy having a composition formula of AlₐY_{b} (90≤a≤96, 4≤b≤10).

In some embodiments, the first sub layer AL may further include nickel (Ni) and/or cobalt (Co). Nickel and cobalt may be elements stabilizing the amorphous phase. In some embodiments, the first sub layer AL may include a ternary alloy or a quaternary alloy. In some embodiments, the first sub layer AL may include a quaternary alloy having a composition formula of AlₐM_{b}Ni_{c}Co_{d}. Here, M may include at least one rare-earth element selected from among Y, Sm, Ce, and La. a, b, c, d each indicate a content (at%) of each element with reference to the total atomic weight of the first sub layer AL, and a sum of a, b, c, and d may be 100. In some embodiments, a may be about 80 or greater but not more than about 90; b may be about 5 or greater but not more than about 10; c may be about 3 or greater but not more than about 8; and d may be about 1 or greater but not more than 3. In other words, with reference to the total atomic weight of the first sub layer AL, a content of aluminum may be about 80 at% or greater but not more than about 90 at%; a content of the rare-earth element M may be about 5 at% or greater but not more than about 10 at%; a content of nickel may be about 3 at% or greater but not more than about 8 at%; and a content of cobalt may be about 1 at% or greater but not more than about 3 at%. In an embodiment, the first sub layer AL may include an alloy having a composition formula of Al₈₅Y₈Ni₅Co₂.

The second sub layer CL may include aluminum (Al). The second sub layer CL may include a pure aluminum layer. The second sub layer CL may include crystalline aluminum. Pure aluminum undergoes plastic deformation after elastic deformation, and may have a relatively low elastic strain limit compared with the elastic strain limit of an amorphous alloy. For example, pure aluminum may have a low elastic strain limit of about 0.2 % to about 0.5 %. Pure aluminum may have low resistivity less than 10 microohm-centimeters (µΩ·cm).

The first layer L1 of the conductive layer SCL may have a structure in which the first sub layer AL and the second sub layer CL are alternately stacked. In an embodiment, FIG. 10 illustrates that the first layer L1 has an eleven-layer structure and includes six first sub layers AL1, AL2, AL3, AL4, AL5, and AL6 and five second sub layers CL1, CL2, CL3, CL4, and CL5. For convenience of explanation, the six first sub layers AL1, AL2, AL3, AL4, AL5, AL6 will be referred to as a 1-1 sub layer AL1, a 1-2 sub layer AL2, a 1-3 sub layer AL3, a 1-4 sub layer AL4, a 1-5 sub layer AL5, and a 1-6 sub layer AL6, respectively, and five second sub layers CL1, CL2, CL3, CL4, and CL5 will be referred to as a 2-1 sub layer CL1, a 2-2 sub layer CL2, a 2-3 sub layer CL3, a 2-4 sub layer CL4, and a 2-5 sub layer CL5, respectively. A top layer and a bottom layer of the first layer L1 may each include the first sub layer AL. For example, FIG. 10 illustrates that the top layer of the first layer L1 is the 1-6 sub layer AL6, and the bottom layer is the 1-1 sub layer AL1. In other words, in the first layer L1, each of the second sub layers CL may be disposed between the first sub layers AL.

The 1-1 sub layer AL1 to the 1-6 sub layer AL6 may include the same material. The 1-1 sub layer AL1 to the 1-6 sub layer AL6 may each include an alloy of aluminum and a rare-earth element having the same composition. In addition, the 2-1 sub layer CL1 to the 2-5 sub layer CL5 may each include the same material. The 2-1 sub layer CL1 to the 2-5 sub layer CL5 may each include a pure aluminum layer.

To reduce the resistivity of the first layer L1, the 1-1 sub layer AL1 to the 1-6 sub layer AL6 may be provided in the substantially same thickness. The 2-1 sub layer CL1 to the 2-5 sub layer CL5 may be provided in the substantially same thickness.

Although FIG. 10 illustrates that the first layer L1 has the eleven-layer structure, the disclosure is not limited thereto. In another embodiment, the first layer L1 may include at least one second sub layer CL and at least two first sub layers AL disposed under and on the second sub layer CL. In consideration of the thickness of the first layer L1 functioning as a wiring or an electrode, the first layer L1 may have a structure including three to twenty-five layers.

In an embodiment, the thickness of the first layer L1 may be from about 300 nanometers (nm) to about 1000 nm.

In an embodiment, a thickness of the first sub layer AL may be from about 30 nm to about 100 nm. Desirably, the thickness of the first sub layer AL may be from about 40 nm to about 80 nm.

In an embodiment, a ratio of the thickness of the first sub layer AL to a thickness of the second sub layer CL may be less than about 2. Desirably, the ratio of the thickness of the first sub layer AL to the thickness of the second sub layer CL may be greater than 0 and not more than about 1. When the ratio of thickness of the first sub layer AL and the second sub layer CL satisfies the desirable range, the first layer L1 may have an extraordinary resistivity property (i.e., 11 µΩ·cm or less).

Referring to FIG. 10, in an embodiment, the conductive layer SCL may include a lower barrier layer L2 under the first layer L1 and an upper barrier layer L3 on the first layer L1. The conductive layer SCL may have a structure in which the lower barrier layer L2, the first layer L1, and the upper barrier layer L3 are sequentially stacked. In an embodiment, the lower barrier layer L2 may include a second layer, and the upper barrier layer L3 may include a third layer. The lower barrier layer L2 and the upper barrier layer L3 may include materials different from a material of the first layer L1. The lower barrier layer L2 and the upper barrier layer L3 may each include a metal material, a transparent conductive oxide, or a nitride. In an embodiment, the metal material may include, for example, molybdenum (Mo), copper (Cu), titanium (Ti), nickel (Ni), chromium (Cr), tungsten (W), and alloys thereof, e.g., NiTi, CuTi, CuMn, and CuMg. The transparent conductive oxide may include, for example, indium tin oxide (ITO). The nitride may include, for example, titanium nitride (TiN). In an embodiment, the lower barrier layer L2 and the upper barrier layer L3 may include Ti or Mo. In an embodiment, the lower barrier layer L2 and the upper barrier layer L3 may have a microstructure that is crystalline or amorphous. Referring to FIG. 11, in another embodiment, the conductive layer SCL may not include the lower barrier layer L2 and the upper barrier layer L3. The conductive layer SCL may be provided only as the first layer L1.

A structure of the aforementioned conductive layer SCL may be applied to the wiring WL disposed in the first bridge portion 12. The wiring WL disposed in the first bridge portion 12 may include the first layer L1 having a structure in which the first sub layer AL including an alloy of aluminum and the rare-earth element and the second sub layer CL including aluminum are alternately stacked. For example, the first wiring WL1, the second wiring WL2, and the third wiring WL3 illustrated in FIG. 9 may include the first layer L1 having the structure in which the first sub layer AL including an alloy of aluminum and the rare-earth element and the second sub layer CL including aluminum are alternately stacked.

Referring to FIG. 12, in a comparative example, the wiring disposed in the first bridge portion may have a structure of a conductive layer SCL'. A first layer L1' of the conductive layer SCL' may not include a stack structure including sub layers. The first layer L1' may include an alloy of aluminum and the rare-earth element, and may include an amorphous alloy layer. In this case, the first layer L1' may have a high elastic strain limit. The resistivity of the first layer L1' may be reduced by adjusting contents of aluminum and the rare-earth element. However, the first layer L1' may have high resistivity compared to resistivity of a pure aluminum layer.

However, according to an embodiment, the wiring WL disposed in the first bridge portion 12 may have the structure of the conductive layer SCL described with reference to FIGS. 10 and 11. The first layer L1 of the conductive layer SCL may include the first sub layer AL including an alloy of aluminum and the rare-earth element and the second sub layer CL including aluminum, and may have a structure in which the first sub layer AL and the second sub layer CL are alternately stacked. In this case, by alternately stacking the first sub layer AL and the second sub layer CL having different physical properties, the first layer L1 may have resistivity that is improved (i.e., lower resistivity) compared with resistivity of the first layer L1' illustrated in FIG. 12. The first layer L1 in an embodiment may secure resistivity similar to low resistivity of a pure aluminum layer while maintaining a high elastic strain limit.

In an embodiment, the resistivity of the first layer L1 may be less than about 11 µΩ·cm. More desirably, the resistivity of the first layer L1 may be greater than about 5 µΩ·cm and less than about 11 µΩ·cm. More desirably, the resistivity of the first layer L1 may be greater than about 5.6 µΩ·cm and less than about 11 µΩ·cm.

In an embodiment, the elastic strain limit of the first layer L1 may be at least about 2.0 %. Desirably, the elastic strain limit of the first layer L1 may be at least about 3.0 %. More desirably, the elastic strain limit of the first layer L1 may be at least about 3.0 % but not more than about 4.0 %. As the first layer L1 has the high elastic strain limit of at least about 2.0 %, in the first bridge portion 12 having the serpentine shape, limit on a design area of the wiring WL may be reduced. In addition, when a tensile strength is applied to the first bridge portion 12 and the first bridge portion 12 extends in various directions, the danger of destroying of the wiring WL may be reduced, and lifespan of the wiring WL may effectively increase.

In an embodiment, a yield strength of the first layer L1 may be at least about 0.7 gigapascals (GPa) but not more than about 1.5 GPa. Desirably, the yield strength of the first layer L1 may be at least about 0.8 GPa but not more than about 1.5 GPa. More desirably, the yield strength of the first layer L1 may be at least about 0.8 GPa but not more than about 1.2 GPa.

In an embodiment, the structure of the conductive layer SCL may also be applied to connection electrodes arranged in the first island portion 11. The connection electrodes may be disposed between the inorganic insulator layer IOL and the light-emitting element. The connection electrodes may be disposed between the gate electrode GE of the thin-film transistor TFT and the light-emitting element, and may be electrically connected to the thin-film transistor TFT and/or the light-emitting element. For example, the connection electrodes may be disposed between the inorganic insulator layer IOL and the first organic insulating layer 119. Alternatively, the connection electrodes may be disposed between the first organic insulating layer 119 and the second organic insulating layer 121. Alternatively, the connection electrodes may be disposed between the second organic insulating layer 121 and the third organic insulating layer 123. For example, the connection electrodes may include the source electrode SE, the drain electrode DE, the first connection electrode CM1, the second connection electrode CM2, and the second voltage line VSSL, which are illustrated in FIG. 9. The connection electrodes arranged in the first island portion 11 may include the first layer L1 having the structure in which the first sub layer AL and the second sub layer CL are alternately stacked, where the first sub layer AL includes the alloy of aluminum and the rare-earth element and the second sub layer CL includes only aluminum. For example, the source electrode SE, the drain electrode DE, the first connection electrode CM1, the second connection electrode CM2, and the second voltage line VSSL may each include the first layer L1 having the structure in which the first sub layer AL and the second sub layer CL are alternately stacked, and the first sub layer AL includes the alloy of aluminum and the rare-earth element and the second sub layer CL includes aluminum. In other embodiments, the structure of the conductive layer SCL may be only applied to the wirings WL arranged in the first bridge portion 12 and not to the connection electrodes arranged in the first island portion 11.

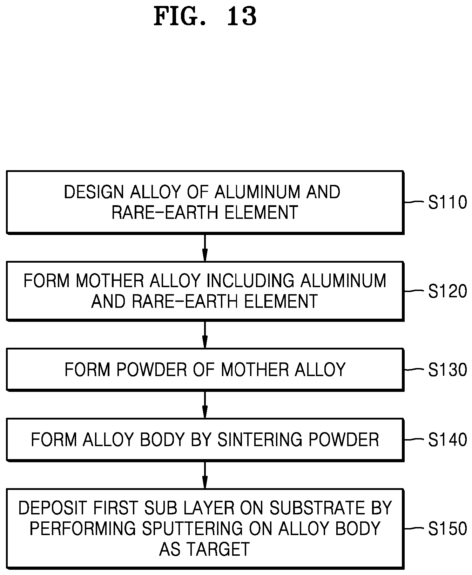

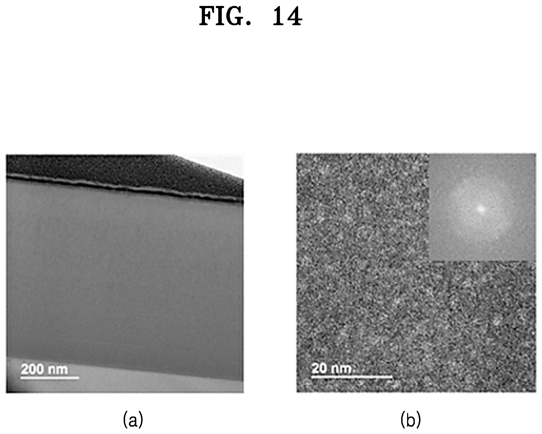

FIG. 13 is a flowchart illustrating a method of manufacturing the alloy layer included in the conductive layer, according to an embodiment; and FIG. 14 illustrates a result of examining the microstructure of the alloy layer according to an embodiment by using a transmission electron microscope ("TEM"). (a) of FIG. 14 illustrates an imaging mode image, and (b) of FIG. 14 illustrates a diffraction mode image.

The method of manufacturing the display apparatus may include: forming the first island portions 11 and the first bridge portions 12 each connecting the first island portions 11 adjacent to each other; and forming the wirings WL (see FIG. 9) arranged in the first bridge portion 12.

As described above, the wirings WL arranged in the first bridge portions 12 may have the structure of the conductive layer SCL (see FIG. 10). The wirings WL arranged in the first bridge portions 12 may each include: the first sub layer AL (see FIG. 10) including the alloy of aluminum and the rare-earth element; and the second sub layer CL (see FIG. 10) including aluminum. The wirings WL arranged in the first bridge portions 12 may each include the structure in which the first sub layer AL and the second sub layer CL are alternately stacked. The forming of the wirings WL may include forming the first sub layer AL, i.e., the alloy layer, and forming the second sub layer CL. In an embodiment, the forming of the first sub layer AL and the second sub layer CL may be performed by a sputtering method.

In an embodiment, the forming of the first sub layer AL may include: designing an alloy of Al and the rare-earth element (S110); forming a mother alloy including Al and the rare-earth element (S120); forming powder of the mother alloy (S130); forming an alloy body by sintering the powder (S140); and depositing the first sub layer AL on a substrate by performing sputtering on the alloy body as a target (S150).

First, in S110, elements and contents in composition of the alloy may be designed. A composition of the target may be designed based on a composition of the first sub layer AL to be finally formed. In an embodiment, the first sub layer AL to be finally formed may include a binary alloy and may have a composition formula of AlₐM_{b}. Here, M may include at least one rare-earth element selected from among Y, Sm, Ce, and La. a and b may each indicate the content (at%) of each element with reference to the total atomic weight of the alloy layer L1, and the sum of a and b may be 100. In an embodiment, a may be at least about 90 but not more than about 96, and b may be at least about 4 but not more than about 10. In other words, with reference to the total atomic weight of the first sub layer AL, the content of aluminum may be at least about 90 at% but not more than about 96 at%, and the content of the rare-earth element M may be least about 4 at% but not more than about 10 at%. In an embodiment, the first sub layer AL may include an alloy having a composition formula of AlₐY_{b} (90≤a≤96, 4≤b≤10).

Next, in S120, the mother alloy may be formed using a high-purity raw material. For example, a vacuum induction melting ("VIM") method and the like may be used to form the mother alloy.

In S130, the powder of the mother alloy may be formed. The mother alloy may be powdered under a highly clean state. Atomizing methods, e.g., an electrode induction gas atomization ("EIGA") method, may be used to form the powder. A size of particles of the powder that has been formed may be from about 30 micrometers (µm) to about 50 µm.

In S140, the alloy body may be formed by sintering the powder. Through the sintering, the alloy body having a uniform composition may be formed. For example, a spark plasma sintering ("SPS") process, a hot isostatic pressing ("HIP") process, and the like may be used to form the alloy body. The alloy body may be processed into a size suitable for a target of the sputtering process.

In S150, the sputtering process may be performed on the alloy body as the target. The first sub layer AL may be deposited on the substrate through the sputtering process. For example, a DC-magnetron sputtering method and the like may be used in the sputtering process.

A microstructure of the first sub layer AL may vary depending on conditions of the sputtering process. For example, the microstructure of the first sub layer AL may vary depending on a temperature, a power density, and a deposition of a sputtering substrate.

Referring to (a) and (b) of FIG. 14, in an embodiment, it is seen that the first sub layer AL is an amorphous alloy layer and has a high-density microstructure that is columnar-free. Compared with the first sub layer AL having a microstructure that is columnar-free, the first sub layer AL has the high-density microstructure that is columnar-free may have extraordinary physical properties (e.g., mechanical properties).

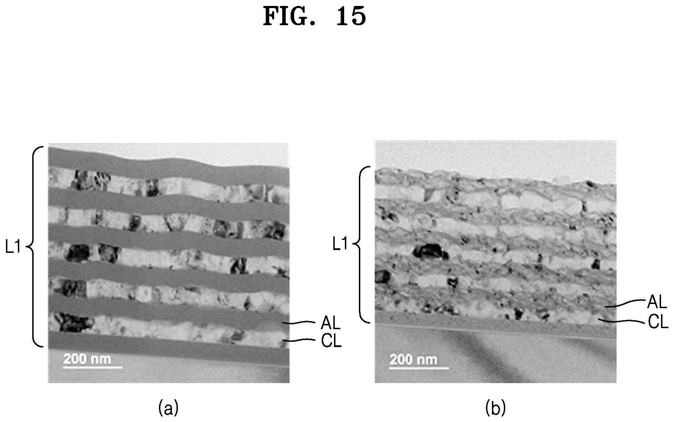

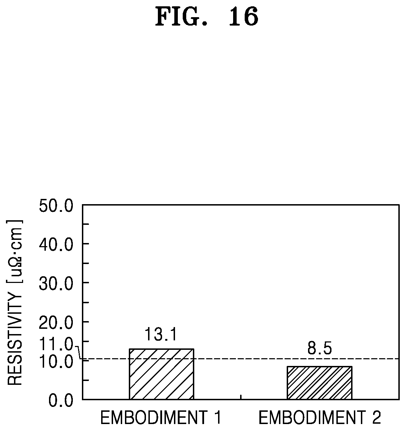

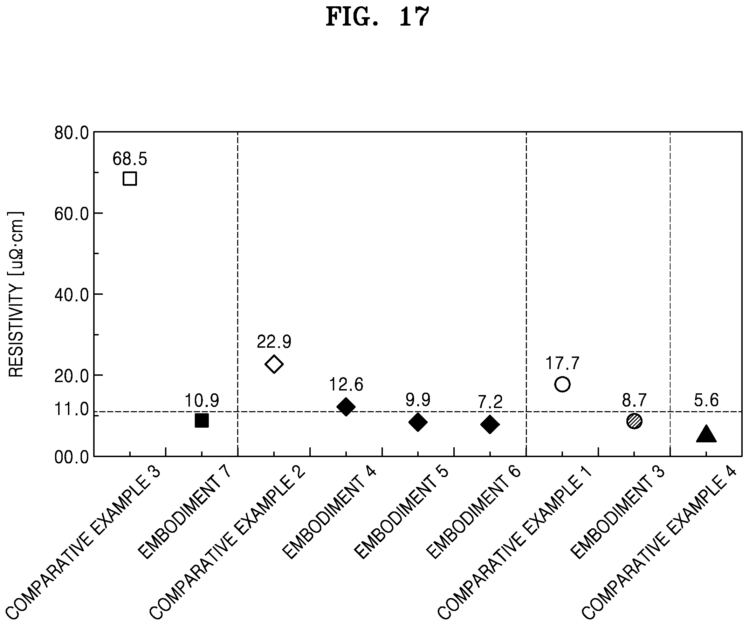

FIG. 15 is a diagram illustrating the microstructure of the conductive layer SCL according to an embodiment. FIG. 16 is a graph showing resistivity of the conductive layer SCL according to embodiments. FIG. 17 is a graph showing resistivity of the conductive layer SCL according to embodiments and comparative examples.

Referring to FIGS. 15 to 17, in each of Embodiments 1 to 7, the first layer L1 in which the first sub layer AL and the second sub layer CL are alternately stacked was formed, in which the first sub layer includes Al and the rare-earth element and the second sub layer CL includes aluminum. More particularly, an amorphous alloy layer including Al and the rare-earth element was formed as the first sub layer AL, and a pure crystalline Al layer was formed as the second sub layer CL. The first layer L1 having the eleven-layer structure was formed by alternately stacking six layers of the first sub layers AL and five layers of the second sub layers CL.

In Embodiments 1 to 7, according to conditions shown in Table 1, the first layer L1 was formed with variation in a kind and a content of the rare-earth element included in the first sub layer AL, the thickness of the first sub layer AL, the thickness of the second sub layer CL, and a ratio of the thickness of the first sub layer AL to the thickness of the second sub layer CL.

**[Table 1]**

| Distinction | A composition of the first sub layer | the thickness of the first sub layer (nm) | the thickness of the second sub layer (nm) | the ratio of the thickness of the first sub layer to the thickness of the second sub layer | a thickness of the first layer (nm) |
|---|---|---|---|---|---|
| Embodiment 1 | Al₉₄Y₆ | 30 | 30 | 1 | 330 |
| Embodiment 2 | Al₉₄Y₆ | 50 | 50 | 1 | 550 |
| Embodiment 3 | Al₉₄Y₆ | 60 | 60 | 1 | 660 |
| Embodiment 4 | Al₉₀Y₁₀ | 80 | 40 | 2 | 680 |
| Embodiment 5 | Al₉₀Y₁₀ | 60 | 60 | 1 | 660 |
| Embodiment 6 | Al₉₀Y₁₀ | 40 | 80 | 1/2 | 640 |
| Embodiment 7 | Al₈₅Y₈Ni₅Co₂ | 60 | 60 | 1 | 660 |

In Comparative Examples 1 to 3, an alloy layer including Al and a rare-earth element was formed. More particularly, an amorphous alloy layer including Al and the rare-earth element was formed. In Comparative Example 1, an alloy layer of Al and Y with a 600 nm thickness and a composition formula of Al₉₄Y₆ was formed. In Comparative Example 2, an alloy layer of Al and Y with a 600 nm thickness and a composition formula of Al₉₀Y₁₀ was formed. In Comparative Example 3, an alloy layer of Al, Y, Ni, and Co with a 600 nm thickness and a composition formula of Al₈₅Y₈Ni₅Co₂ was formed.

In Comparative Example 4, a pure crystalline Al layer was formed. More particularly, an Al layer having a 600 nm thickness was formed.

In Comparative Example 5, a crystalline Al alloy layer (Al7075) was formed.

FIG. 15 illustrates a result of examining the microstructure of the first layer L1 in Embodiments 3 and 7 with a TEM. (a) of FIG. 15 illustrates the microstructure in Embodiment 7, and (b) illustrates the microstructure in Embodiment 3.

Referring to FIG. 15, it is seen that the first layer L1 in Embodiments 3 and 7 has a structure in which the first sub layer AL, i.e., the amorphous alloy layer, and the second sub layer CL, which is crystalline, are alternately stacked. More particularly, it is seen that the first sub layer AL in embodiment 7 is fully amorphous. On the other hand, it is seen that the first sub layer AL in Embodiment 3 exists in a form where a nanocrystalline phase, which has a crystal size of only several nanometers, is distributed in an amorphous phase.

Resistivity was measured with respect to the first layer L1 in Embodiments 1 to 7, the alloy layer in Comparative Examples 1 to 3, and the Al layer in the Comparative Example 4. The resistivity was measured by a 4-point probe ("4PB") method. Results thereof were shown in FIGS. 16 and 17. FIG. 16 shows resistivity in Embodiments 1 and 2, and FIG. 17 shows resistivity in Embodiments 3 to 7 and Comparative Examples 1 to 4.

Referring to FIGS. 16 and 17, it is seen that the resistivities in Embodiments 1 and 2 (13.1 and 8.5 µΩ·cm) are each lower than the resistivity in the Comparative Example 1 (17.7 µΩ·cm). It is also seen that the resistivity in Embodiment 2 is less than 11 µΩ·cm while the resistivity in Embodiment 1 is at least 11 µΩ·cm. When the thickness of the first sub layer AL decreases by at least a certain degree, electrons may be further scattered, and the resistivity of the first layer L1 may increase. To secure the resistivity less than 11 µΩ·cm, the thickness of the first sub layer AL may be at least 40 nm. Desirably, the thickness of the first sub layer AL may be from about 40 nm to about 100 nm. More desirably, the thickness of the first sub layer AL may be from about 40 nm to about 80 nm.

Referring to FIG. 17, it turns out that the resistivity in Embodiment 3 (8.7 µΩ·cm) is less than the resistivity in the Comparative Example 1 (17.7 µΩ·cm), the resistivities in Embodiments 4 to 6 (12.6, 9.9 and 7.2 µΩ·cm, respectively) are each less than the resistivity in the Comparative Example 2 (22.9 µΩ·cm), and the resistivity in Embodiment 7 (10.9 µΩ·cm) is less than the resistivity in the Comparative Example 3 (68.5 µΩ·cm). The resistivities in Embodiments 3, 5, and 7 (8.7, 9.9 and 10.9 µΩ·cm, respectively) are each less than 11 µΩ·cm, similar to the resistivity in Comparative Example 4 (5.6 µΩ·cm), while the resistivities in Comparative Examples 1 to 3 and Embodiment 4 (17.7, 22.9, 68.5 and 12.6 µΩ·cm, respectively) are at least 11 µΩ·cm. Accordingly, it is confirmed that when the ratio of the thickness of the first sub layer to the thickness of the second sub layer is 1 or less, the first layer has the resistivity less than 11 µΩ·cm. From the above embodiments and comparative examples, it is clear that the resistivity varies depending on the thickness of the first sub layer, the ratio of the thickness of the first sub layer to the thickness of the second sub layer, and the content of aluminum with reference to the total atomic weight of the first sub layer.

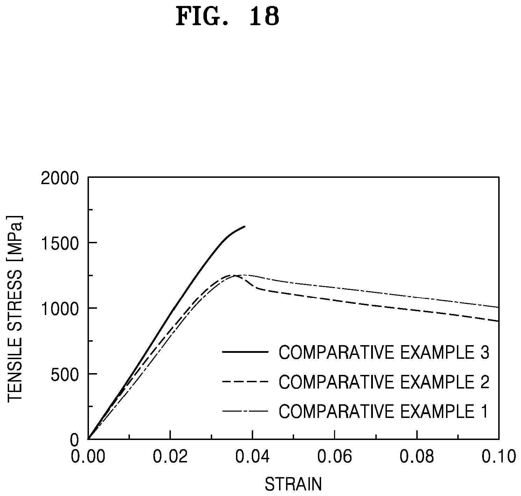

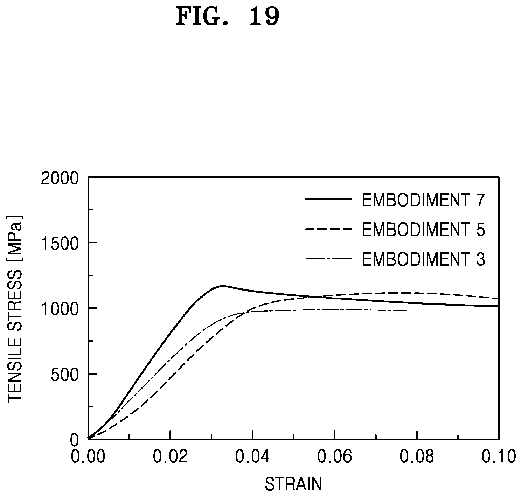

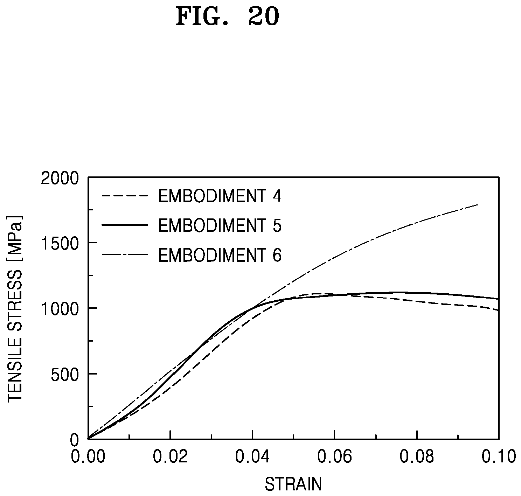

FIG. 18 is a graph showing a result of a tensile strength experiment on the conductive layer, according to comparative examples; FIG. 19 is a graph showing a result of a tensile strength experiment on the conductive layer, according to embodiments; and FIG. 20 is a graph showing a result of a tensile strength experiment on the conductive layer, according to other embodiments.

A tensile strength experiment was performed with respect to the first layers in Embodiments 3 to 7 and the alloy layers in Comparative Examples 1 to 5. The tensile strength experiment was performed in a method of manufacturing test pieces by patterning the first layers or the alloy layers in the form of dog-bones by a focused ion beam ("FIB") method and performing in-situ measurement and recording results of the experiments of the test pieces by using an SEM device mounted with Picoindenter. Results thereof were shown in Table 2 and FIGS. 18 to 20. FIG. 18 is a graph showing a result of comparing Comparative Examples 1 to 3; FIG. 19 is a graph showing a result of comparing Embodiments 3, 5, and 7; and FIG. 20 is a graph showing a result of comparing Embodiments 4, 5, and 6.

**[Table 2]**

| Distinction | elastic strain limit (%) | yield strength [MPa] |
|---|---|---|
| Comparative example 1 | 3.72 | 1255.7 |
| Comparative example 2 | 3.45 | 1249.2 |
| Comparative example 3 | 3.83 | 1625.3 |
| Embodiment 3 | 3.27 | 920.5 |
| Embodiment 4 | 3.30 | 1005.1 |
| Embodiment 5 | 3.15 | 906.2 |
| Embodiment 6 | 3.09 | 1015.9 |
| Embodiment 7 | 3.26 | 1168.5 |
| Comparative example 4 | 0.2 | 124 |
| Comparative example 5 | 0.6 | 503 |

Referring to FIGS. 18 to 20, in Comparative Example 3, the test piece that is fully amorphous was broken while performing elastic deformation without plastic deformation, while the test pieces in Comparative Examples 1 and 2, which have a form in which nanocrystals are scattered in an amorphous phase, underwent plastic deformation after elastic deformation. The test pieces in Embodiments 3 to 7 each have a stack structure including the first sub layer, i.e., an amorphous alloy layer, and the second sub layer, i.e., a crystalline metal layer, and therefore, plastic deformation occurs after elastic deformation.

Referring to Table 2 and FIGS. 18 to 20, it is seen that the test pieces in Comparative Examples 1 to 3 have high elastic strain limits greater than 3.0 %, while test pieces in Comparative Examples 4 and 5 have low elastic strain limits of 0.2 % and 0.6 %, respectively. It is also seen that the test pieces in Embodiments 3 to 7 have elastic strain limits lower than the elastic strain limits in Comparative Examples 1 to 3 but maintain high elastic strain limits of at least 2.0 %, desirably, at least 3.0 %. It is seen that the test pieces in Embodiments 3 to 7 have elastic strain limits greater at least ten times compared with the elastic strain limits in Comparative Examples 4 and 5.

It is seen that the yield strengths in Comparative Examples 1 to 3 are at least 1.2 GPa, while yield strengths in Comparative Examples 4 and 5 are 124 megapascals (MPa) and 503 MPa, which are relatively lower than other Comparative Examples or Embodiments, respectively. It is also seen that yield strengths in Embodiments 3 to 7 are high yield strengths of at least 0.8 GPa, while being lower than the yield strengths in Comparative Examples 1 to 3. It is seen that the yield strengths in Embodiments 3 to 7 are greater at least eight times the yield strength in the Comparative Example 4.

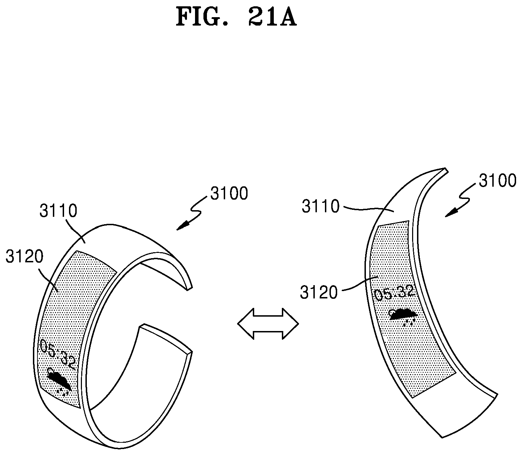

FIGS. 21A to 21G are perspective views each schematically illustrating an embodiment of an electronic device including a display apparatus according to an embodiment.

The display apparatus 1 according to the aforementioned embodiments may be used for various electronic devices by which images may be provided. Here, an electronic device indicates a device, for which electricity may be used and by which certain images may be provided.

Referring to FIG. 21A, the display apparatus according to an embodiment may be used for a wearable electronic device 3100 which may be worn by a part of a user's body. The wearable electronic device 3100 may include a body 3110 and a display 3120 included in the body 3110. The display apparatus according to the embodiments may be used as the display 3120 of the wearable electronic device 3100. The wearable electronic device 3100 of embodiment illustrated in FIG. 21A may be modified. In an embodiment, the wearable electronic device 3100 may be used as a smartwatch or a smartphone according to a choice of the users.

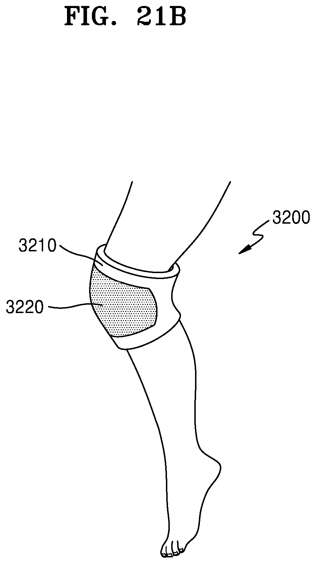

FIG. 21B illustrates a medical electronic device 3200. In an embodiment, the medical electronic device 3200 may include a body 3210 and an emitter 3220. The display apparatus according to the embodiments may be used as the emitter 3220 of the medical electronic device 3200. The emitter 3220 may emit light in a certain wavelength band (e.g., an infrared ray, a visible ray, and/or the like) to the body of the user. In an embodiment, the body 3210 may include a fiber material that is elastic, and the emitter 3220 may have a structure wearable by the body of the user.

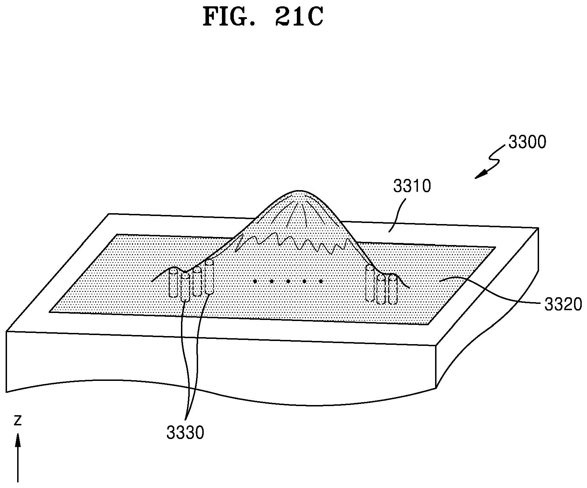

FIG. 21C illustrates an electronic device for education 3300. In an embodiment, the electronic device for education may include a display 3320 provided in a frame 3310. The display apparatus according to the embodiments may be used for the display 3320. Images such as wavering seas, mountains covered with snow, or volcanoes with flowing lava may be provided through the display 3320, and in this case, the display 3320 may extend in a height direction (e.g., the z direction) in reflection of heights of the waves, mountains, or volcanoes. In some embodiments, heights of portions of the display 3320 gradually changes in a direction in which the lava flows, and therefore, movement of the lava may be three-dimensionally seen. The electronic device for education 3300 may include pins (or stroke units 3330) arranged on a rear surface of the display 3320 such that the display 3320 extends in the height direction. As the pins 3330 move in the third direction (e.g., the z direction or the - z direction), the images expressed in the display 3320 may be implemented to have three-dimensional heights. Although the electronic device for education 3300 is described with reference to FIG. 21C, as long as the electronic device provides certain image information, use of the electronic device is not limited thereto.

Although an electronic device having a variable shape is described with reference to the electronic devices illustrated in FIGS. 21A to 21C, the disclosure is not limited thereto. Like in the following embodiments, the display apparatus according to the embodiments may be used for an electronic device in which a portion (e.g. a screen), on which images may be expressed, is fixed.

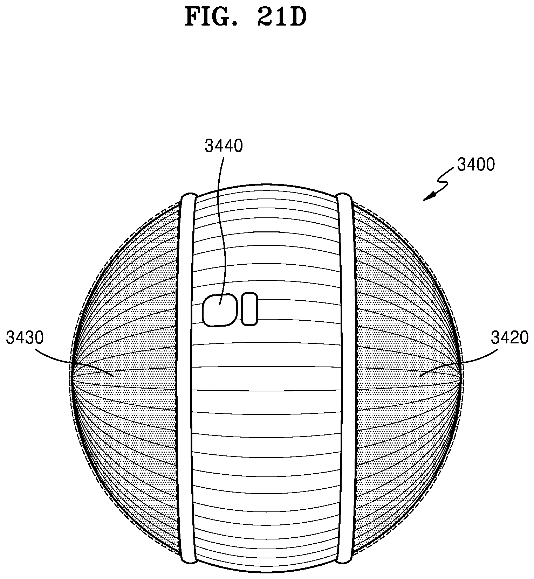

FIG. 21D illustrates a robot 3400 as an electronic device according to an embodiment. The robot 3400 may be configured to recognize movements or objects by using a camera 3440 and display certain images to the user through displays 3420 and 3430. In some embodiments, the display apparatuses according to embodiments may extend in various directions as described above, and thus may be assembled to a body frame having a hemisphere shape, and therefore, the robot 3400 may include the displays 3420 and 3430 having a hemisphere shape.

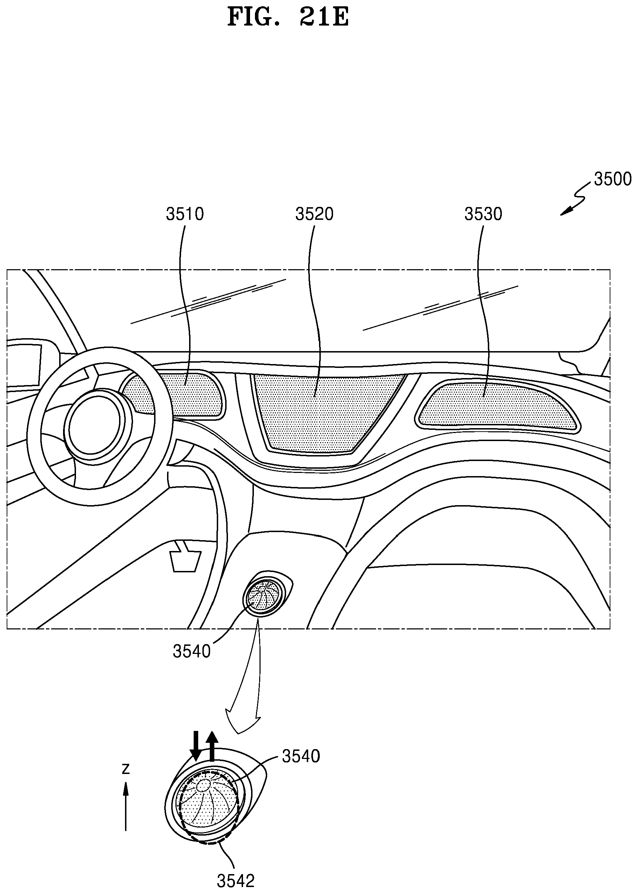

FIG. 21E illustrates a display device for vehicle 3500 as an electronic device according to an embodiment. The display device for vehicle 3500 may include a cluster 3510, a center information display ("CID") 3520, and/or a passenger display 3530. As the display apparatus according to the embodiments may extend in various directions, and thus may be used for the cluster 3510, the CID 3520, and/or a co-driver display (i.e., the passenger display) 3530 regardless shapes of inner frames of vehicles.

Although FIG. 21E illustrates that the cluster 3510, the CID 3520, and/or the co-driver display 3530 are separate from one another, the disclosure is not limited thereto. In other embodiments, at least two components selected from among the cluster 3510, the CID 3520, and the co-driver display 3530 may be integrally connected.

In some embodiments, the display device for vehicles 3500 may include a button 3540 for expressing certain images. Referring to a magnified image shown in FIG. 21E, the button 3540 having a hemisphere shape may include an object 3542 moving in the z direction or - z direction and providing a sense of use of the button and a display apparatus disposed on the object 3542. In some embodiments, when the object 3542 has a three-dimensionally rounded surface, the display apparatus may also have a three-dimensionally rounded surface.

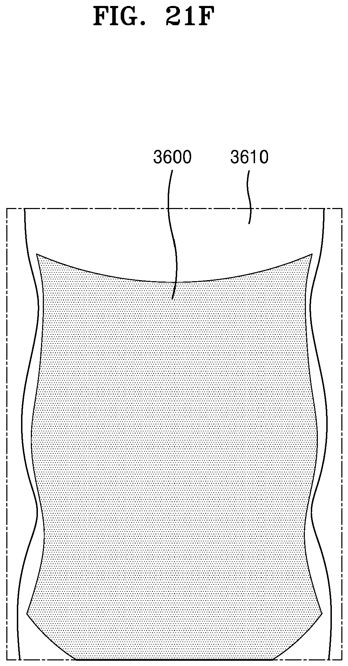

FIG. 21F illustrates that an electronic device according to an embodiment includes an electronic device for advertisements or exhibitions 3600. In some embodiments, the electronic device for advertisements or exhibitions 3600 may be mounted on a structure 3610 that is fixed, e.g., a wall or a pillar. When the structure 3610 includes a rough surface as illustrated in FIG. 21F, the electronic device for advertisements or exhibitions 3600 may also be arranged along the rough surface of the structure 3610. In some embodiments, the electronic device 3600 for advertisements or exhibitions may be mounted on the structure 3610 by using a thermostatic film and the like.

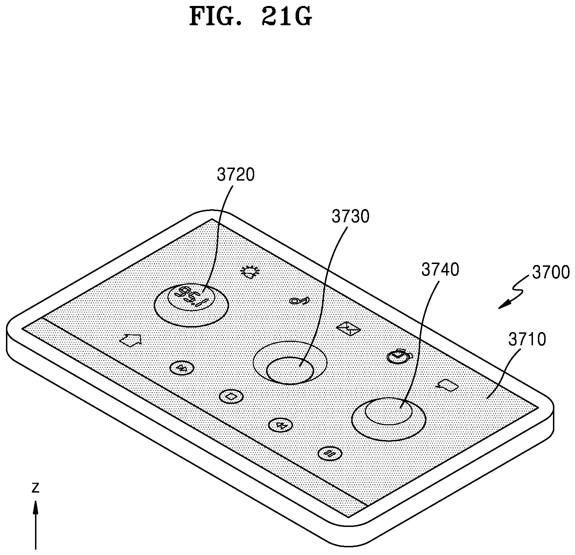

FIG. 21G illustrates that an electronic device according to an embodiment includes a controller 3700. The controller 3700 may include image-type buttons. For example, the controller 3700 may include a first button area 3720, a second button area 3730, and a third button area 3740, that is, some areas of the display 3710 protruding in the z direction or - z direction (or being recessed in the z direction). In some embodiments, the first button area 3720 and the third button area 3740 may protrude in the z direction, and the second button area 3730 may protrude in the - z direction (or be recessed in the z direction).

While the present invention has been described with reference to an embodiment shown in the drawings, it will be understood by those of ordinary knowledge in the art that these are just examples and various changes and equivalent other embodiments may be made therefrom.. Accordingly, the true technical scope of the present invention should be defined by the technical concept of the appended claims.

## Claims

1. A display apparatus comprising a display area and a non-display area outside the display area, the display apparatus comprising:
a plurality of island portions arranged in the display area and spaced apart from one another;
a plurality of bridge portions each connecting adjacent island portions among the plurality of island portions; and
a plurality of wirings arranged in the plurality of bridge portions,
wherein each of the plurality of wirings comprises a first layer,
wherein the first layer comprises a first sub layer and a second sub layer,
wherein the first sub layer comprises an alloy of aluminum (AI) and a rare-
earth element, and the second sub layer comprises aluminum.

2. The display apparatus of claim 1, wherein each of the first sub layer and the second sub layer is provided in plurality, and the first layer has a structure in which the plurality of first sub layers and the plurality of second sub layers are alternately stacked.

3. The display apparatus of claim 2, wherein two first sub layers of the plurality of first sub layers are arranged on a top portion and a bottom portion of the first layer, respectively.

4. The display apparatus of claim 1, wherein the first sub layer comprises an amorphous alloy layer.

5. The display apparatus of claim 1, wherein the rare-earth element comprises at least one of yttrium (Y), samarium (Sm), cerium (Ce), or lanthanum (La).

6. The display apparatus of claim 1, wherein a content of the rare-earth element is 4 at% to 10 at% with respect to a total atomic weight of the first sub layer.

7. The display apparatus of claim 2, wherein a ratio of a thickness of each of the plurality of first sub layers to a thickness of each of the plurality of second sub layers is not more than 1.

8. The display apparatus of claim 1, wherein resistivity of the first layer is greater than 5.6 µΩ·cm and less than 11µΩ·cm.

9. The display apparatus of claim 1, wherein an elastic strain limit of the first layer is at least 2.0 %.

10. The display apparatus of claim 1, wherein a yield strength of the first layer is 0.8 GPa to 1.2 GPa.

11. The display apparatus of claim 1, wherein
each of the plurality of wirings further comprises a second layer under the first layer and a third layer on the first layer, and
the second layer and the third layer comprise materials different from a material of the first layer.

12. The display apparatus of claim 1, wherein
each of the plurality of island portions comprises
a transistor comprising a semiconductor and a gate electrode;
a light-emitting element electrically connected to the transistor; and
an electrode disposed between the gate electrode and the light-emitting element,
wherein the electrode comprises a third sub layer and a fourth sub layer, the third sub layer comprising an alloy of aluminum and a rare-earth element and the fourth sub layer comprising aluminum.

13. A display apparatus comprising a display area and a non-display area outside the display area, the display apparatus comprising:
a plurality of island portions arranged in the display area and each comprising a transistor and a light-emitting element electrically connected to the transistor; and
a plurality of bridge portions each connecting adjacent island portions among the plurality of island portions,
wherein each of the plurality of bridge portions comprises a wiring electrically connected to a transistor of any one of the adjacent island portions,
wherein the wiring comprises a first layer, and
the first layer comprises a first sub layer and a second sub layer, the first sub layer comprising an alloy of aluminum and a rare-earth element and
the second sub layer comprising aluminum.

14. The display apparatus of claim 13, wherein each of the first sub layer and the second sub layer is provided in plurality, and the first layer has a structure in which the plurality of first sub layers and the plurality of second sub layers are alternately stacked.

15. The display apparatus of claim 14, wherein two first sub layers of the plurality of first sub layers are arranged on a top portion and a bottom portion of the first layer, respectively.

16. The display apparatus of claim 13, wherein the rare-earth element comprises at least one of yttrium (Y), samarium (Sm), cerium (Ce), or lanthanum (La).

17. The display apparatus of claim 13, wherein a content of the rare-earth element is 4 at% to 10 at% with respect to a total atomic weight of the first sub layer.

18. The display apparatus of claim 14, wherein a ratio of a thickness of each of the plurality of first sub layers to a thickness of each of the plurality of second sub layers is greater than 0 and not more than 1.

19. The display apparatus of claim 13, wherein a resistivity of the first layer is greater than 5.6 µΩ·cm and less than 11 µΩ·cm.

20. The display apparatus of claim 13, wherein an elastic strain limit of the first layer is at least 2.0 %.

21. The display apparatus of claim 13, wherein a yield strength of the first layer is 0.8 GPa to 1.2 GPa.
